# EUROPEAN PATENT APPLICATION

(11) **EP 1 703 572 A1**
(43) Date of publication of application: **20.09.2006**
(21) Application number: 05001448.9
(22) Date of filing: 25.01.2005
(51) Int. Cl.: H01L 51/05

(54) **Molecular rectifiers**

(71) Applicant: SONY DEUTSCHLAND GmbH, 50829 Köln (DE)
(72) Inventor: Wessels, Jurina Stuttgart Technology Center, 70327 Stuttgart (DE); Ford, William E. Stuttgart Technology Center, 70327 Stuttgart (DE); Nothofer, Heinz-Georg Stuttgart Technology Center, 70327 Stuttgart (DE); Kron, Gregor Stuttgart Technology Center, 70327 Stuttgart (DE); von Wrochem, Florian Stuttgart Technology Center, 70327 Stuttgart (DE); Yasuda, Akio Stuttgart Technology Center, 70327 Stuttgart (DE)
(74) Representative: Krauss, Jan

(57) **Abstract**

The present invention relates to molecules exhibiting rectifying properties. In particular, the present invention relates to a molecular rectifying assembly, comprising the general structure METAL₁-CON₁-BRIDGE-CON₂-METAL₂ in which CON₁ and CON₂ are a connecting group or connecting part and independently of each other are molecular groups bound to METAL_{1,2} in such a way that an adsorbate state with an energy close to the Fermi energy of the metal is formed at one or both of the METAL_{1,2}/CON_{1,2} interfaces, METAL is selected from metals and/or alloys of metals, and BRIDGE is the core of the molecule, consisting of pi-conjugated and non-conjugated parts. Furthermore, the present invention relates to uses of said molecular rectifying assembly or the production of electronic devices where molecules are placed between at least two electrodes.

## Description

The present invention relates to molecules exhibiting rectifying properties. In particular, the present invention relates to a molecular rectifying assembly, comprising the general structure METAL₁-CON₁-BRIDGE-CON₂-METAL₂ in which CON₁ and CON₂ are a connecting group or connecting part and independently of each other are molecular groups bound to METAL_{1,2} in such a way that an adsorbate state with an energy close to the Fermi energy of the metal is formed at one or both of the METAL_{1,2}/CON_{1,2} interfaces METAL_{1,2} is selected from metals and/or alloys of metals, and BRIDGE is the core of the molecule, consisting of pi-conjugated and non-conjugated parts. Furthermore, the present invention relates to uses of said molecular rectifying assembly or the production of electronic devices where molecules are placed between at least two electrodes.

All references as cited herein are incorporated by reference in their entireties for the purposes of the present invention.

### Background of the Invention

The trends of miniaturization of electronic circuit elements has progressed continuously since the invention of the integrated circuit. The number of transistors per chip has steadily increased as the feature sizes continued to decrease. When the dimensions of the electronic devices decrease below 10 nm, the device performance will suffer because of quantum limitations and cross talk. Thus at these dimensions new technologies may evolve using individual or groups of molecules as electronic devices performing computations based on novel architectures.

Since the seminal introduction of the first molecular rectifier by Aviram and Ratner [1] based on a Donor-Insulator-Acceptor mechanism, selected molecular rectifiers based on different concepts have been proposed and experimentally realized. In addition, molecular wires and molecular switches have been fabricated, electrically characterized and partially also used for the realization of molecular memories using crossbar structures, consisting of aligned electrodes, bars, or wires that are organized in two planes forming a two-dimensional grid, wherein molecules are placed at the intersecting points between the bars, electrodes, or wires (data lines).

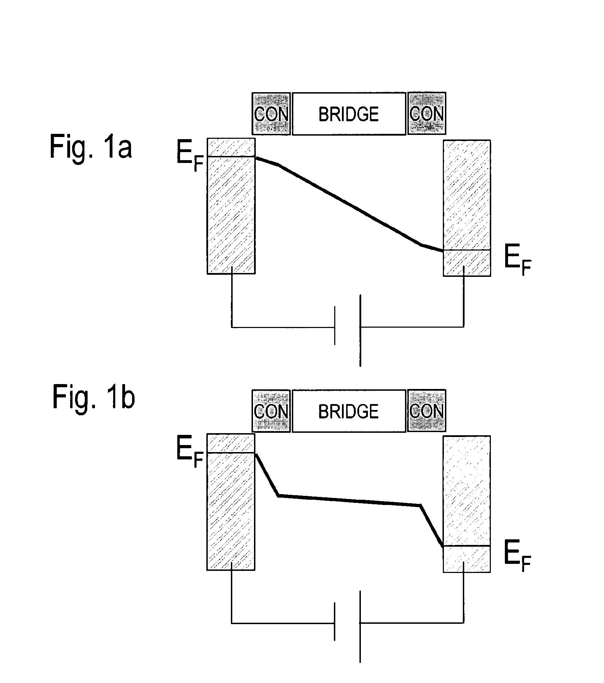

Molecules exhibiting rectifying properties are key for the realization of molecular electronic logic devices based on crossbar structures. It is therefore an object of the present invention, to provide novel molecules exhibiting rectifying properties that exhibit advantageous properties. The main problem in designing functional molecules, such as rectifiers, is to find a metal binding group that provides an excellent electrical coupling to the metal, so that the applied potential drops across the molecule (Fig. 1a) and not across the metal/molecule interface (Fig. 1b). Other objects will become apparent from the description of the present invention as provided in the following.

In one aspect of the present invention, the object is solved by providing general structures and component parts for fabricating molecular rectifiers having a small potential drop at the interface at one or both metal/molecule interfaces. The present invention therefore relates to a molecular rectifying assembly, comprising the general structure

METAL₁-CON₁-BRIDGE-CON₂-METAL₂

in which CON₁ and CON₂ are a connecting group or connecting part and independently of each other are molecular groups bound to METAL_{1,2} in such a way that an adsorbate state with an energy close to or in resonance with the Fermi energy of the metal is formed at one or both of the METAL_{1,2}/CON_{1,2} interfaces, METAL_{1,2} is selected from metals and/or alloys of metals, and BRIDGE is the core of the molecule, consisting of pi-conjugated and non-conjugated parts.

This invention concerns the realization of asymmetric molecules of the general structure CON₁-BRIDGE-CON₂ where one or both ends of the molecule that bind to the metal in the molecular rectifying assembly is a dithiocarbamate or dithiocarbamate derivative, which will be generally abbreviated herein as DTC. In this generalized notation of the molecular structure, it is recognized that certain atoms or ions, or groups or combinations thereof, may leave the asymmetric molecule when the rectifying assembly METAL₁-CON₁-BRIDGE-CON₂₋METAL₂ is produced. For example, if the CON₁ end of the rectifying assembly has the form METAL₁-S-BRIDGE, the group at that end of the asymmetric molecule, before assembly, could be, for example, a thiol group (HS-), a protected thiol group (e.g., CH₃C(O)S-), or a disulfide group (-SS-). In the case of that the CON₁ end of the rectifying assembly has the form METAL₁-DTC-BRIDGE, the group at that end of the asymmetric molecule, before assembly, could be, for example, a dithiocarbamate salt group (M^{+ -}S₂CNH- or M^{+ -}S₂CNR'-), a dithiocarbamate ester group (RS(S)CNH- or RS(S)CNR'-), a bis-dithiocarbonimidate group ((RS)₂CN-), or a thiram group (-NHC(S)S-S(S)CNH- or -NR'C(S)S-S(S)CNR'-), wherein M⁺ represents a cationic species such as, for example, Na⁺ or NH₄⁺, and the groups R and R' independently of each other represent small organic residues such as, for example, methyl (CH₃), ethyl (CH₂CH₃), or phenyl (C₆H₅).

One aspect of the present invention further proposes to utilise dithiocarbamate derivatives as metal-binding groups for the realization of the metal/molecule interface in molecular rectifiers. The dithiocarbamate (DTC) group exhibits good pi-delocalisation in the NCS₂ plane, which is formed by the overlap between two p orbitals from the sulfur atoms, one p orbital from the nitrogen and one from the carbon atom [2]. Both S atoms bind equivalently to Au and the free electron is delocalised between the two sulfur atoms. According to Ariafard et al. a charge deficiency on the sulfur atoms leads to a charge deficiency in the *p*_{*z*} orbital of the carbon atom, forcing the lone pair of the nitrogen atom to shift to the carbon atom and hence strengthening the π character of the C-N bond [3].

Upon attaching a dithiocarbamate group to a Au cluster, the electron density of molecular orbitals that are not solely associated with the gold cluster extends over the cluster and the conjugated part of the molecule. Thus if a benzene ring is directly attached via a dithiocarbamate group to a metal electrode, the electron density of the molecular orbitals that are not solely associated with the cluster extend all the way from the cluster to the benzene ring.

The general structures of the molecular rectifiers that are proposed here consist of a) mono-dithiocarbamate derivatives coupled to metal electrodes, and b) bis-dithiocarbamate derivatives coupled to metal electrodes having the general structure:

METAL₁-CON₁-BRIDGE-CON₂-METAL₂

where BRIDGE represents the core of the molecule, CON₁and CON₂ denotes the connecting (coupling or metal-binding) groups, and METAL₁ and METAL₂ represent the metal electrodes, which may be, independently of each other, in the form of, for example, a data line, a scanning probe tip, or a metal particle. At least one of the connecting groups (CON₁ and CON₂) is a dithiocarbamate or derivative of a dithiocarbamate, and the metal comprising the electrodes (METAL₁ and METAL₂) may be the same or different. In one aspect of the present invention, CON₁ and CON₂ independently can be identical or different.

Theoretical investigations using a first-principles atomistic approach revealed that an increase in the atomic number of the anchoring group provides a better contact to the electrode [4]. Thus, Se and Te provide a superior contact to Au than S. In the cases of S and Se contacts, the Fermi level lies between the HOMO-LUMO gaps, while for Te the HOMO is in resonance with the Fermi level.

The effect of the metal-molecule contact on the I-V characteristics of molecules was demonstrated using rigid π-conjugated oligo(phenylene ethynylene) having an α-thio and a ω-thio , a ω-methyl, a ω-pyridine or a ω-nitro functionalities [5]. The large voltage drop at the methyl/metal interface leads to strong current rectification in the molecule having a α-thio and an ω-methyl functionality. This is also the case for the oligo(phenylene ethynylene) having an ω-nitro functionality. This suggests that the nitro functionality does not provide a good contact to the metal. In contrast, both the oligo(phenylene ethynylene) with an α-thio and an ω-thio or an ω-pyridine group show symmetric I-V characteristics, indicating that electronic coupling of the pyridine group to Au is comparable with that of thiol to Au [5]. Rigid monophenyl, bi-phenyl and terphenyl rings have been used in order to investigate the difference between isocyanide and thiol binding groups experimentally [6] and theoretically [7]. This investigation showed that in case of a thiol (SH) binding group, the conductance gap decreased as the number of phenyl rings increased, while in case of the isocyanide (-NC) binding group, the conductance gap increases with increasing number of phenyl rings. This is probably due to the fact that the π-orbitals of the isocyanides strongly interact with the π-orbitals of the phenyl rings and the energy of their HOMO level increases with increasing number of phenyl rings enhancing the electron donating capabilities of the isocyanide group. Thus the isocyanide group becomes more positive upon binding to Au as the number of phenyl rings increases, leading to a lowering of the isocyanide orbital energy away from the Fermi energy.

So far, mainly thiols and disulfides have been used for the attachment of molecules to metals. However, in both cases the electronic coupling between the sulfur atom and the Au atom is weak because the Au-S (thiol) bond has a low density of states. The Au-S bond has a very low density of states. The Au atoms contribute *s* states at the Fermi level while the sulfur atom contributes *p* states. By symmetry, only the *p* states that are perpendicular to the electrode surface can couple to the *s* states of the Au forming σ bonds. The *p* states of the S atom that are parallel to the metal surface do not couple to the Au *s* states [8], thereby constituting a barrier for charge transport.

The metal is furthermore preferably selected from the group comprising the metals of the Group 12 elements, the Group 13 elements, the Group 14 elements, and the Transition elements, where the latter are broadly defined as elements that have partly filled *d* or *f* shells in any of their commonly occurring oxidation states. More preferably, the metal is independently selected from the group comprising Au, Ag, Pd, Pt, Cr, Cu, Ti, Ni and combinations of these metals and alloys thereof. Thus, yet another aspect of the present invention relates to a molecular rectifying assembly, wherein the metal is independently selected from the group comprising Au, Ag, Pd, Pt, Cr, Cu, Ti, Ni, and combinations of these metals, and alloys thereof. The metals can be the same or different.

Another preferred aspect of the present invention relates to a molecular rectifying assembly, wherein in BRIDGE-CON-METAL the group -CON- is selected from -NHCS₂- (dithiocarbamate); -NHC(SR)S- (dithiocarbamate ester); -NC(SR)₂- (bis-dithiocarbonimidate); - NR'CS₂- (dithiocarbamate, N-substituted); -NR'C(SR)S- (dithiocarbamate ester, N-substituted); -NH₂- (amine); -NC- (isonitrile); -NR'PS₃- (trithiophosphoroamidate); -S- (thiolate); -S(SR)- (disulfide); -SCS₂- (trithiocarbonate); -SC(SR)S- (trithiocarbonate ester); -CN-(nitrile); -CS₂- (dithiocarboxylate); -C(SR)S- (dithiocarboxylate ester); -COS- (thiocarboxylate); -COSR- (thiocarboxylate ester); -C₅H₄N- (pyridine); -C₃H₃N₂- (imidazole); -COO-(carboxylate); -OCS₂- (xanthate); -OC(SR)S- (xanthate ester); -OP(OR)S₂- (dithiophosphate); -OP(OR)(SR')S- (dithiophosphate ester); -PR₂- (phosphine); -PS₃- (trithiophosphonate);-P(SR)₂S- (trithiophosphonate ester); -B(SR)S- (thioborate ester); -BS₂- (thioborate); -Te-(tellurate) and -Se- (selenate); wherein the group R and R' independently of each other represent small organic residues, such as, for example, methyl (CH₃), ethyl (CH₂CH₃), and phenyl (C₆H₅).

Another preferred aspect of the present invention relates to a molecular rectifying assembly, wherein the group BRIDGE is selected from pi-conjugated and non-conjugated parts, having the general structure (pi-conjugated)(non-conjugated) or (non-conjugated)(pi-conjugated)(non-conjugated) or (non-conjugated)ₓ(pi-conjugated)(non-conjugated)_{y}. More preferred is a molecular rectifying assembly according to the present invention wherein (non-conjugated)ₓ and (non-conjugated)_{y} independently are different in length.

Another preferred aspect of the present invention relates to a molecular rectifying assembly, wherein the pi-conjugated part is selected from the group of 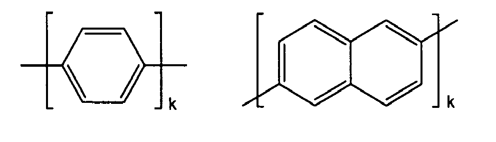 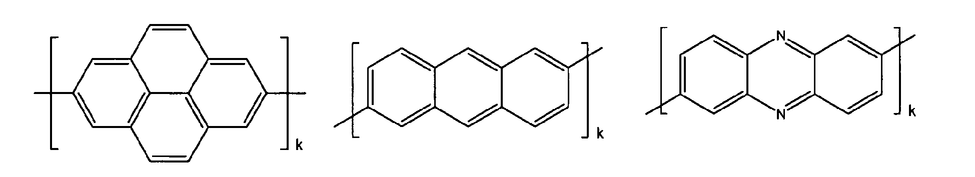 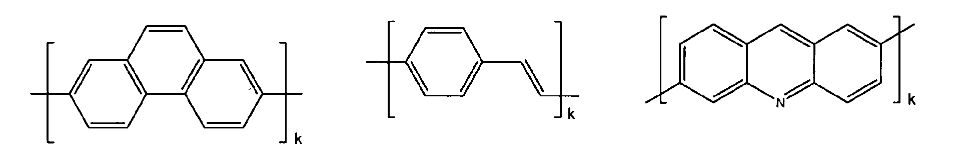 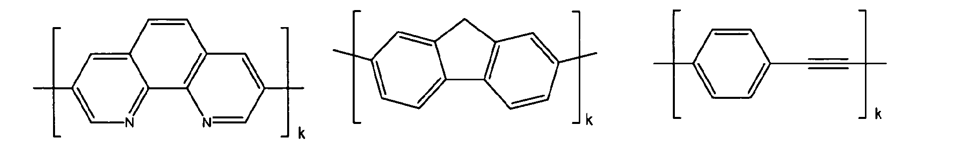 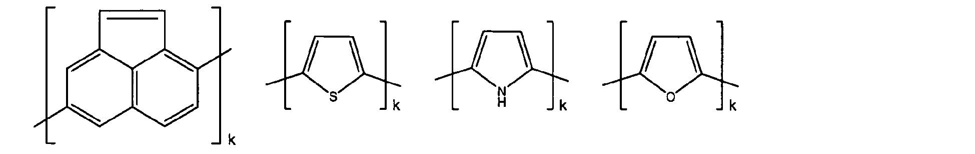 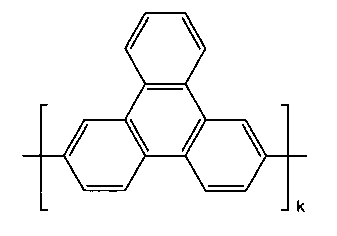 wherein k is selected from integers between and including 1 to 6, preferably between and including 1 to 4, further functionalized derivatives thereof. Also preferred is a molecular rectifying assembly according to the present invention, wherein the non-conjugated part is selected from the group of straight alkane chains, cyclic or polycyclic aliphatic carbon skeletons, 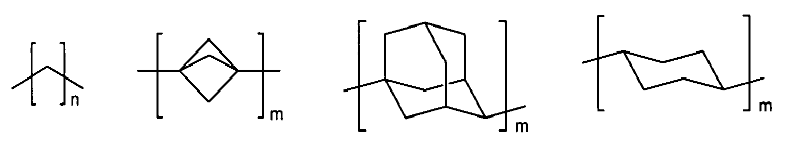 wherein n is selected from integers between and including 1 to 18, preferably between and including 1 to 14, and m is selected from integers between and including 1 to 5, and further functionalized derivatives thereof.

It should be evident to anyone skilled in the art that one or more of the hydrogen atom (H) substituents of these particular pi-conjugated parts may be replaced by other atoms or groups of atoms for connecting the pi-conjugated parts to other pi-conjugated parts or to non-conjugated parts of the molecule, or to modify the electronic properties of the molecular rectifying assemby. For example, an alkyl chain (non-conjugated part) may be attached to an aromatic ring (pi-conjugated part) directly, i.e. through a methylene (CH₂) group, or indirectly, e.g. through an ether (O) group. Also by way of example, replacement of the hydrogen atoms by halogen atoms (F, Cl, Br, I), organic groups containing halogen atoms, such as CF₃, C≡N, and NO₂ tends to lower the chemical potential of the pi-conjugated part, while replacement of the hydrogen atoms by organic groups such as CH₃, OCH₃, and N(CH₃)₂ tend to increase the chemical potential of the pi-conjugated part. It should also be evident to anyone skilled in the art that one or more of the methylene (CH₂) groups within the skeleton of these particular non-conjugated parts may be replaced by other atoms or groups of atoms for connecting the non-conjugated parts to other non-conjugated parts or to pi-conjugated parts of the molecule, or to modify the structural properties of the molecular rectifying assembly. For example, replacement of the hydrogen atoms by bulkiers atoms or groups, such as I or CH₃, will affect the way that the molecules pack within the assembly. Hydrogen atoms may also be replaced by groups such as OH or CONH₂ to provide hydrogen-bonding capabilities between the molecules. It should also be evident to anyone skilled in the art that one or more of the carbon atoms within the skeleton of these particular non-conjugated parts may be replaced by other atoms or groups of atoms to modify the structural properties of the molecular rectifying assembly. For example, a (CH₂)₃ unit within a hydrocarbon chain can be replaced by (CH₂)₂O or (CH₂)₂NH, to introduce a greater degree of flexibility or to provide hydrogen-bonding capabilities between the molecules. Molecules that contain such substituents as described above will be understood as "functionalized derivatives" in the context of the present invention.

In the context of the present invention, a "tunnel barrier" is a region in space characterized by a potential energy, which is higher than the kinetic energy of an approaching electron. Due to the wavelike behavior the electron has a finitie probability of crossing the potential barrier. This process is called tunneling.

In the context of the present invention, an "adsorbate state" is a state that is formed upon the formation of a bond between a molecule and a metal as a result of the mixing between molecular orbitals and metal states. The energy levels of the adsorbate states are broadened. The electron density of the adsorbates states is delocalized over the metal and the metal binding group and hence provides an excellent electronic coupling between metal and molecule.

Another preferred aspect of the present invention relates to a molecular rectifying molecule, wherein one of the metal coupling groups is a dithiocarbamate derivative selected from the general formula BRIDGE-NHCS₂-METAL, and BRIDGE-NR'CS₂-METAL, wherein BRIDGE and METAL are as indicated above and wherein the group R' represents a small organic residue, such as methyl (CH₃), ethyl (CH₂CH₃), and phenyl (C₆H₅).

Yet another preferred aspect of the present invention relates to a molecular rectifying molecule, wherein said molecule is selected from the group of 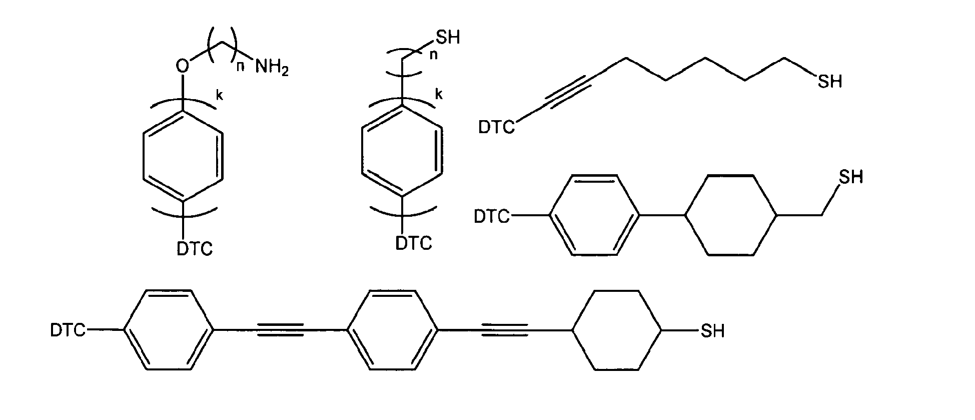 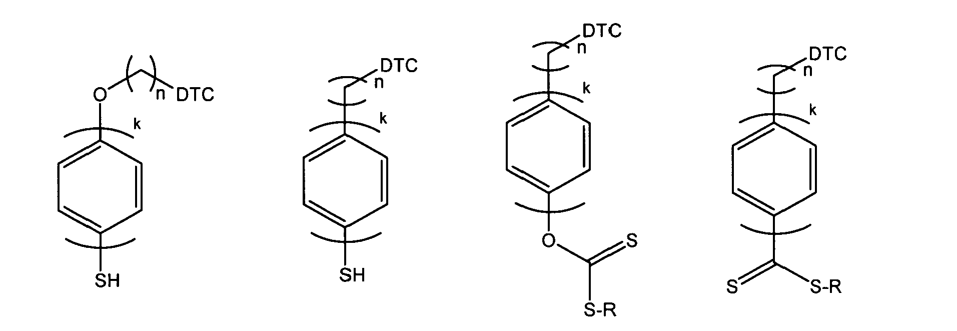 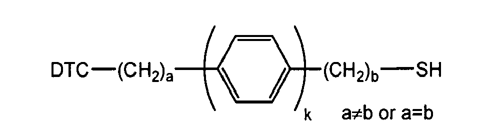 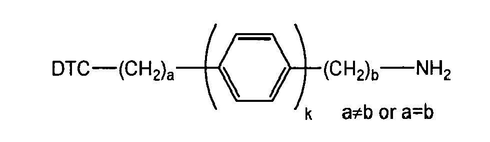 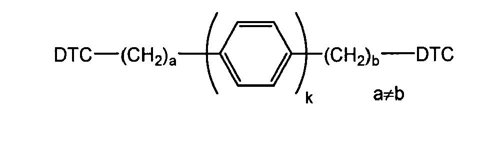 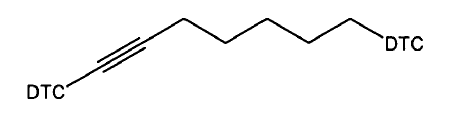 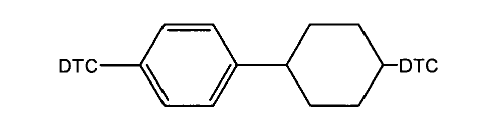 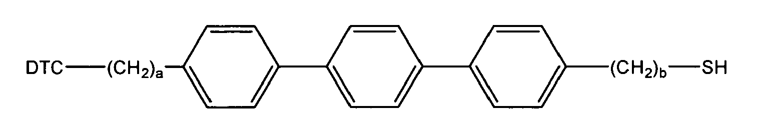 wherein a, n and b, m are selected from integers between and including 1 and 18, and wherein the group R represents a small organic residue, such as methyl (CH₃), ethyl (CH₂CH₃), and phenyl (C₆H₅), and functionalized derivatives thereof.

In an even more preferred molecular rectifying assembly according to the present invention, said non-conjugated parts independently have a length of between and including 1-23 Å, preferably between and including 1-20 Å, most preferred between and including 1-16 Å.

**Directed assembly of molecules -** Critical for the fabrication of devices comprising several asymmetric molecules is to control the molecular orientation in the assembled film.
Langmuir-Blodgett deposition can be used to orient amphiphilic molecules on surfaces [9]. Alternatively, molecules with only one metal binding group have been used to construct molecular rectifiers that assemble with a controlled orientation on the surface [10]. Thus, another general aspect of the present invention is related to a method for producing a molecular rectifying assembly as described above, wherein said method comprises the steps of providing different protecting groups and sequential deprotection of the metal binding groups. More preferred, in the method according to the present invention the molecule contains a dithiocarbamate ester group or a derivative thereof, and said method comprises the steps of protecting the thiol via trimethylsilylethyl (TMSE), and removing the TMSE by tetrabutylammonium fluoride in THF after the assembly of molecules with the dithiocarbamate ester facing to the metal. Most preferred is a method according to the present invention, comprising the step of providing a particular orientation to the molecule during adsorption onto the metal surface by introducing interacting side groups into the molecule and/or chemically modifying the molecule after formation of the self-assembled monolayer (SAM).

In both cases, however, the requirement for the control over the molecular orientation limits the possibilities to the design the molecular backbone in order to optimise e.g. rectification properties of molecules.

Pollack et al. demonstrated that sequential deprotection of aryl dithiols allows to position α,ω - dithio functionalized molecules with an asymmetric central core such as 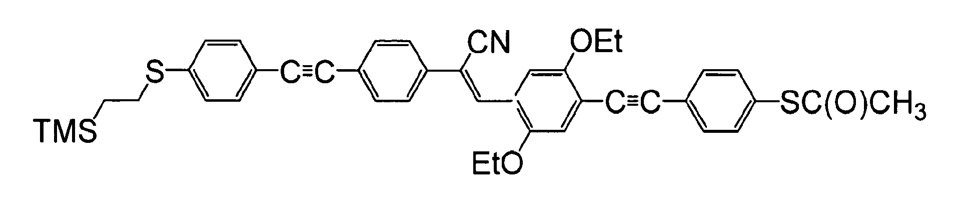 with a preferred polar order [11]. Deprotection of the thioacetate was achieved under acidic conditions (concentrated sulfuric acid) in the presence of gold, while the trimethylsilylethyl (TMSE) protecting group was removed by immersion into a THF solution of tetrabutylammonium fluoride.

A further possibility for introducing orientation of molecules in SAMs through the assembly process is to implement hydrogen bonding moieties at one side of the molecule. The formation of hydrogen bonds within the SAM is the driving force for controlling the orientation of the molecules in the SAM.

In yet another aspect, the method comprises the step of activating terminal carboxylic acid groups of SAMs of 11-mercaptoundecanoic acid and subsequently reacting them with amines or alcohols to form amide or ester linkages or converting of the amine group to the dithiocarbamate group, a salt or ester derivative thereof in the solution phase.

Finally, the present invention relates to the use of a molecular rectifying assembly as above for the production of electronic devices where molecules are placed between at least two electrodes.

**Rectifying molecules -** Molecular rectifiers are potentially one of the key enabling electronic components for the realization of molecular memories and molecular logic. These applications require molecular rectifiers with high rectification ratios and sharp voltage thresholds. So far, molecular rectifiers based on six different concepts have been introduced.

### 1. Donor-σ-Acceptor

Aviram and Ratner [1] introduced a Donor-Insulator-Acceptor mechanism as a molecular rectifier. In this concept D is a strong electron donor and A is a strong electron acceptor. An insulating bridge consisting of non-conjugated σ bonds separates D and A. If such a molecule is placed between two electrodes, the I-V characteristics should be asymmetric if the zwitterionic state D⁺-σ-A⁻ is relatively easily accessible from the neutral ground state and the opposite zwitterionic state D⁻-σ-A⁺ lies significantly higher in energy. In the forward direction the electrons tunnel inelastically from the LUMO of D via the insulating σ bridge to the low-lying HOMO of A when the Fermi level of the electrodes line up with the LUMO of A and the HOMO of D.

### 2. Energy mismatch between two localized energy levels

A slight variation of the Donor-σ-Acceptor mechanism was introduced by Ellenbogen and Love [12]. This mechanism is based on molecules consisting of two conducting levels that are isolated from each other by an insulating bridge consisting of non-conjugated σ-bonds. In the forward direction both conducting levels align at a certain applied bias facilitating resonant tunneling through the molecule. In the reverse direction, the applied bias leads to a further separation of the conducting levels and hence to a suppression of the tunnel current.

Both cases require a very good electrical isolation between the two molecular systems that are responsible for the rectification and the potential drop across the electrode/molecule interface and the insulating barrier as well as the location of the LUMO and HOMO relative to the Fermi level under zero bias and under applied bias are key for the design of molecular rectifiers and determine the rectification current and the threshold voltage. These systems have not been experimentally realized.

### 3. Asymmetric position of HOMO and LUMO levels on molecule

A Langmuir Blodgett monolayer of a hexadecylquinolinium tricyanoquinodimethanide between Mg and Pt electrodes [13-15] as well as between Al electrodes [16, 17] has been used in order to provide experimental verification of the Donor-σ-Acceptor mechanism. However, theoretical modeling revealed that hexadecylquinolinium tricyanoqinodimethanide is a Donor-π -Acceptor molecule [18]. The rectification ratios (RR = (current at V₀)/(current at -V₀)) obtained from multilayers of hexadecylquinolinium tricyanoquinodimethanide sandwiched between Al electrodes varied between 2.4 and 26.4. The rectification ratio decreased continuously with each repeated cycle and disappeared after 4-6 cycles. Theoretical modelling showed that the asymmetry in the I-V characteristics of D-π. A systems is due to asymmetric positions of the LUMO and HOMO with respect to the Fermi level and to the asymmetric profile of the electrostatic potential across the molecule [18]. Furthermore the calculations showed that the presence of tunnel barriers like alkyl chains at the D or A side have a pronounced influence on the charge transport characteristics.

The D-σ -A and D-π -A rectifiers are complex molecular systems. Application of a bias potential leads to large inhomogeneous electric fields resulting from the molecular dipoles and the screening induced by the molecules themselves and the electrodes. Such systems are very difficult to describe theoretically and to simulate the expected I-V characteristics. Large discrepancies between theoretical modeling and experimental results have been described for hexadecylquinolinium tricyanoquinodimethanide [18].

### 4. Asymmetry of HOMO and LUMO levels with respect to E_{F} and asymmetrically positioned electroactive unit

A general and simple concept for molecular rectification has been introduced by Kornilovitch et al. [19]. In this concept a single electroactive unit is positioned asymmetrically between two electrodes and the HOMO and LUMO are placed asymmetrically with respect to the Fermi energy E_{F}. Thus it is sufficient to have one conducting molecular level located between two different tunnel barriers between electrodes. Based on the assumption that most of the potential drops across the larger tunnel barrier, the conditions for resonant tunneling are achieved at very different voltages for both directions [19]. The molecules have the general structure:

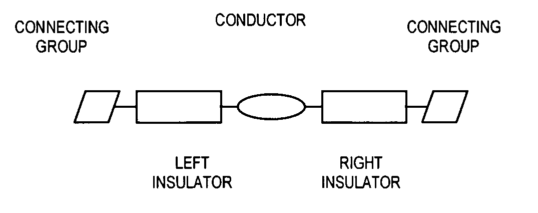

They consist of a central conjugated island located between two insulating barriers I_{L} and I_{R}. The island provides an energy level, which is not too far from the Fermi energies of the electrodes. The end groups can for example be thiols or they may be absent altogether if the application does not require a strong contact. One molecular structure that resembles such molecular rectifiers is HS-(CH₂)_{*a*}-C₆H₄-(CH₂)_{*b*}-SH. The two main parameters determining the rectification ratio are the energy difference between the LUMO and the Fermi energy of the electrodes and the potential drop across the two insulating barriers. Thus a pronounced increase in conductivity is expected when the Fermi level of the electrode to which the smaller tunnel barrier is attached aligns with the LUMO of the isolated conductive part of the rectifier. The onset in current is due to resonant tunneling through the LUMO of the conjugated unit of the molecule. Theoretical calculations have shown that the highest rectification ratio of RR~500 is obtained for molecules where a=2 and b=10 [19]. The optimization of the rectification ratio is limited by the low conductivity of the non-conjugated molecular bonds that are required for the realization of the two insulating parts, since even alkane chains as short as C₁₂H₂₅ are fairly resistive [20].

Additional possible structures for molecular rectifiers disclosed by Kornilovitch et al. are shown below:

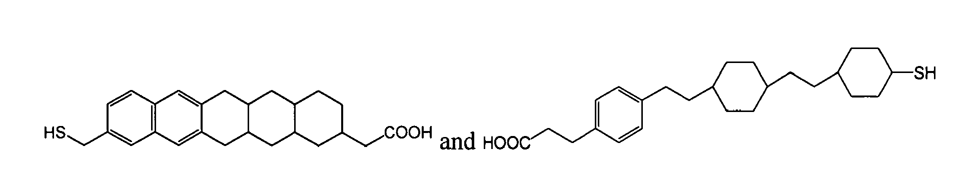

According to the theoretical calculations of Kornilovitch et al., the results should be independent of the nature of the connections to the electrodes at both ends. They suggest that the end- or binding groups can be adjusted to the desired experimental set-up or that they can be absent [19].

### 5. Asymmetric coupling to electrodes

A further possibility for realizing rectification in a metal-molecule-metal junction is to couple a molecule to two metals that have different work functions. Asymmetric contacts can induce asymmetric I-V characteristics in symmetric molecules through differential charging. The characteristics of the asymmetry depend on whether the occupied or unoccupied molecular orbitals contribute to the charge transport through the molecule. Thus the asymmetry can be switched by altering the applied potential to induce either conduction through the occupied or unoccupied molecular orbitals. This effect has been experimentally observed, however, the rectification ratio was negligibly small [21].

### 6. Asymmetric central unit

An asymmetric I-V characteristic was also observed for a molecule that had an asymmetric central benzene ring. The molecule was coupled at both ends via SH to Au electrodes. The asymmetry was introduced by substituting the benzene ring on the 2 and 5 positions with an electron donating amide group and with an electron withdrawing NO₂ group, respectively [22]. However, the observed asymmetry was very small and the rectification was insignificant.

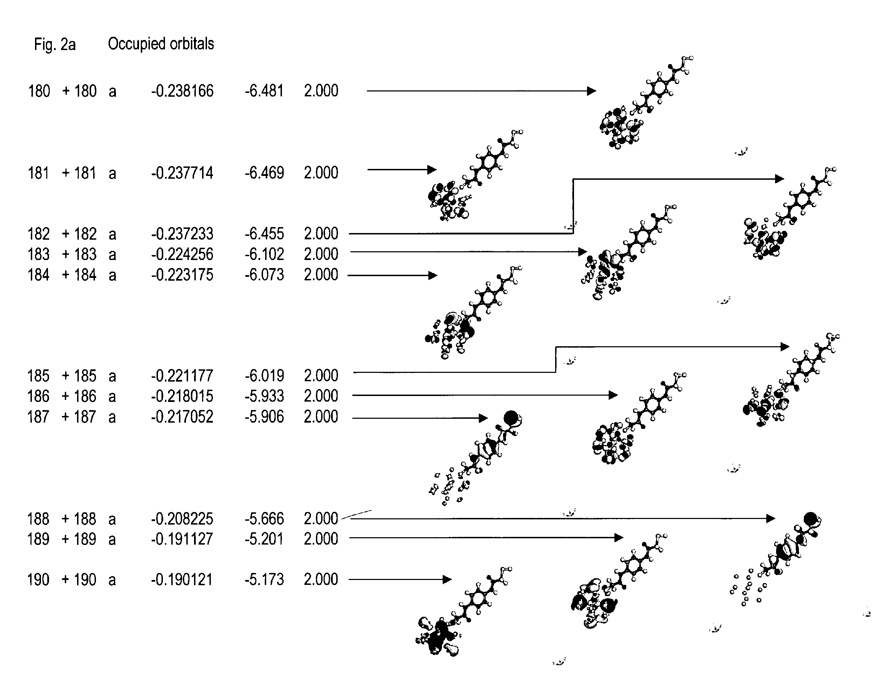

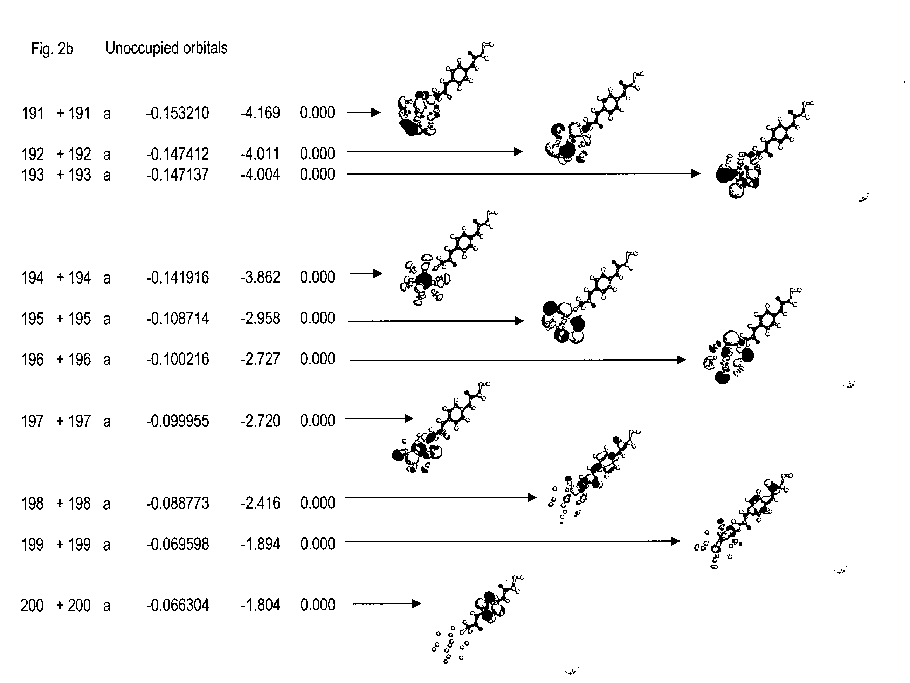

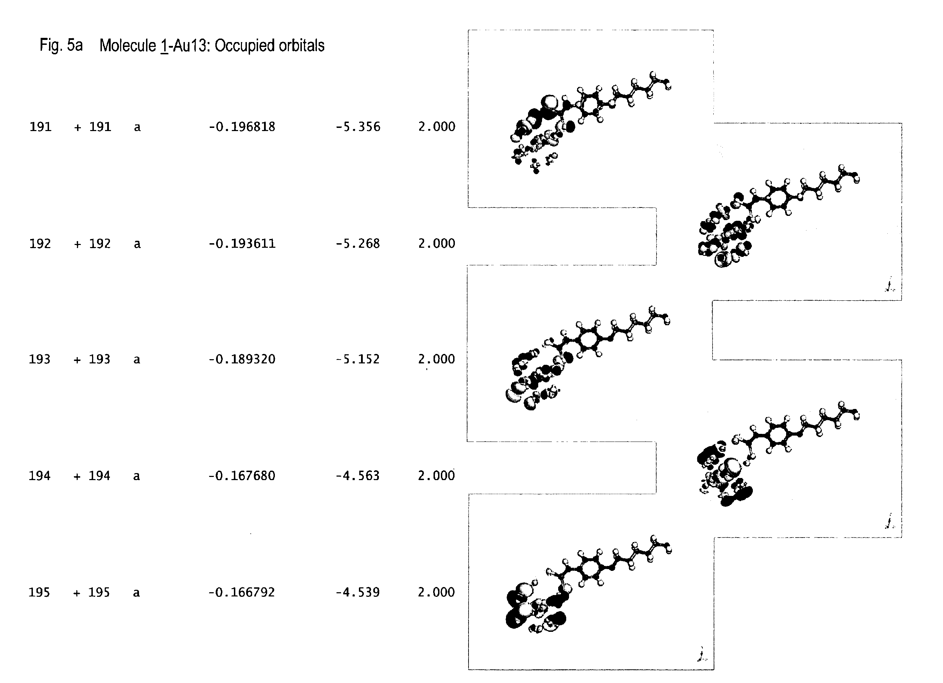

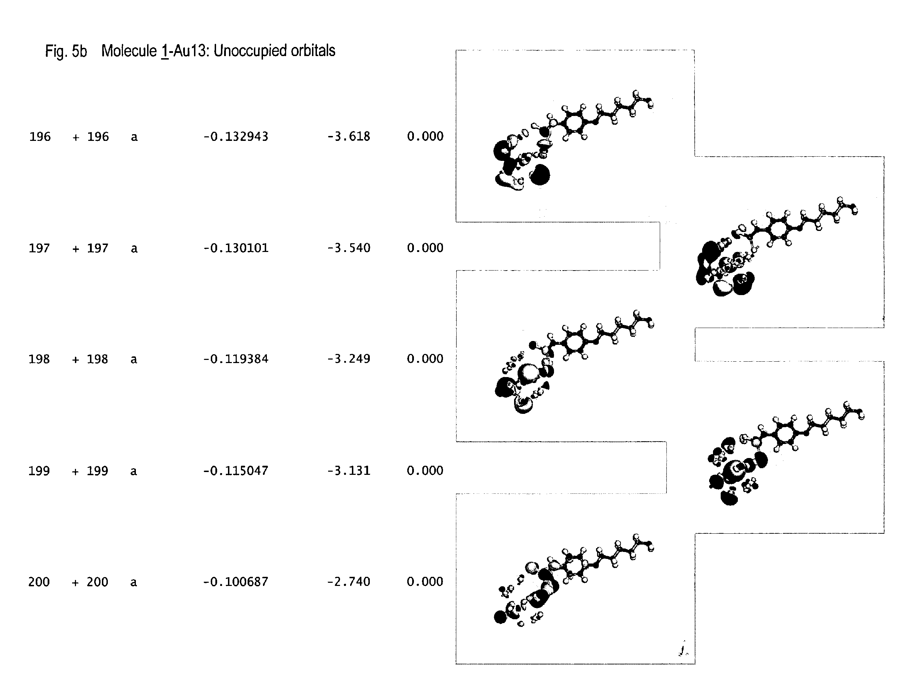

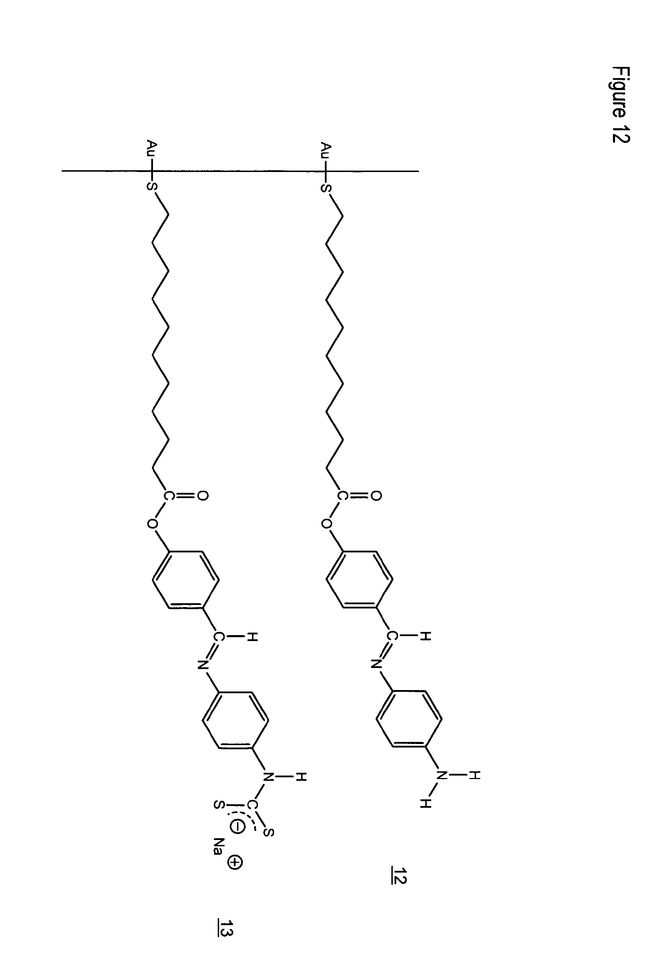

The present invention shall now be further described by the following examples with reference to the accompanying figures, without being limited to said examples. All theoretical calculations were performed using Density Functional Theory (DFT) at the generalized gradient approximation level with either the PW91 functional (Figures 1 and 2) or with the BLYP functional (Figures 5-12) as provided by the Dmol3 program. A double numerical basis set provided with polarization functions (dnd) for all atoms except Hydrogen together with a real space cut-off of 4.5 Å was used. The Density Functional Semi-core Pseudopotentials (DSPP) allow the explicit treatment of only the 19 valence electrons of Au, while the remaining 60 inner electrons are treated as a core. All structures including the Au₁₃ cluster were first relaxed to find the minimum energy structure and then orbitals and energies were calculated as shown in the Figures.

The Ultraviolet Photoelectron Spectroscopy (UPS) spectra were recorded with an Axis Ultra from Kratos. The photoelectrons were excited with a He lamp (He II) at the Energy of 40.8 eV and the spectra detected with a 165mm radius hemispherical analyzer.

In the figures,
**Figure 1:** shows a schematic representation of a metal-molecule-metal junction with a connecting group providing a good contact to the metal leads (a) and with a connecting group providing a bad contact to the metal (b).
**Figure 2:** shows the electron density of the first seven occupied and the first eight unoccupied molecular orbital energy levels, respectively, for a dimercaptoacetamido-benzene molecule coupled at one end to a Au₁₃ cluster.
**Figure 3:** shows the electron density of the first eight occupied (a) and unoccupied (b) molecular orbital energy levels, respectively, for a phenylene-bis-dithiocarbamate molecule coupled at one end to a Au₁₃ cluster.
**Figure 4:** shows ultraviolet photoelectron emission (UP) spectra of self-assembled monolayers of decanethiol (---―), phenylenebisdithiocarbamate (---―) and of thiram (···) on Au (111).
**Figure 5:** shows the electron density of the first five occupied (a) and five unoccupied (b) molecular orbital energy levels, respectively, for molecule 1 coupled with the dithiocarbamate end to a Au₁₃ cluster.
**Figure 6:** shows the electron density of the first eleven occupied (5a) and nine unoccupied (5b) molecular orbital energy levels for molecule 2 with a Au₁₃ cluster attached to the dithiocarbamate group, respectively.
**Figure 7:** shows the electron density of the first six occupied and six unoccupied molecular orbital energy levels for molecule 3 with a Au₁₃ cluster attached to the dithiocarbamate group (6a and b) and attached to the thiol group (6c and d), respectively.
**Figure 8:** shows the electron density of the first seven occupied and four unoccupied molecular orbital energy levels for molecule 4.
**Figure 9:** shows the electron density of the first twelve occupied and nine unoccupied molecular orbital energy levels for molecule 5.
**Figure 10:** shows a segment-by-segment growth process to provide an Au-S-(pi-conjugated)(non-conjugated)-DTC assembly.
**Figure 11:** shows a segment-by-segment growth process to provide an Au-S-(non-conjugated)(pi-conjugated)(non-conjugated)-DTC assembly.
**Figure 12:** shows a segment-by-segment growth process to provide an Au-S-(non-conjugated)(pi-conjugated)-DTC assembly.

### Examples

A detailed study has been performed in order to investigate the influence of the metal binding group and the degree of conjugation on the charge transport through symmetrical bifunctional linker molecules in 3-dimensional assemblies of interlinked gold nanoparticles [23, 24]. The observed optical and experimental results indicate that the bond formation between Au and the dithiocarbamate group leads to the formation of an adsorbate state with an energy that is close to the energy of the Fermi level of Au.

Theoretical modeling of various molecules with dithiocarbamate and thiol binding groups attached to Au₁₃-clusters using DFT generalized gradient approximation (PW91 functional) further supported the experimental findings. The calculated orbitals of the molecule-cluster complexes reveal notable difference between the dithiocarbamate-Au- and the thiol-Au coupling. Figure 2a and b show the electron density of the first seven occupied and the first eight unoccupied molecular orbital energy levels, respectively, for a dimercaptoacetamido-benzene molecule coupled at one end to a Au₁₃ cluster. The wavefunction of the occupied orbitals is localized mainly on the Au cluster with a small contribution of the sulphur *p*-orbitals, except for HOMO-2 and HOMO-4 and HOMO-3. HOMO-2 is delocalised over the molecule but has no contribution on S and Au. HOMO-4 and HOMO-3, which are almost degenerate, are localized on the molecule and on the cluster but show a deficiency on the C and S atoms that form the contact. Similarly, the unoccupied molecular orbitals (Fig. 2b) are mainly localized on the cluster. Only LUMO+8 is delocalised over the whole molecule-cluster complex. Since the energy gap between HOMO and LUMO+8 is 2.7 eV HOMO-3/HOMO-4 are probably the main channels for charge transport.

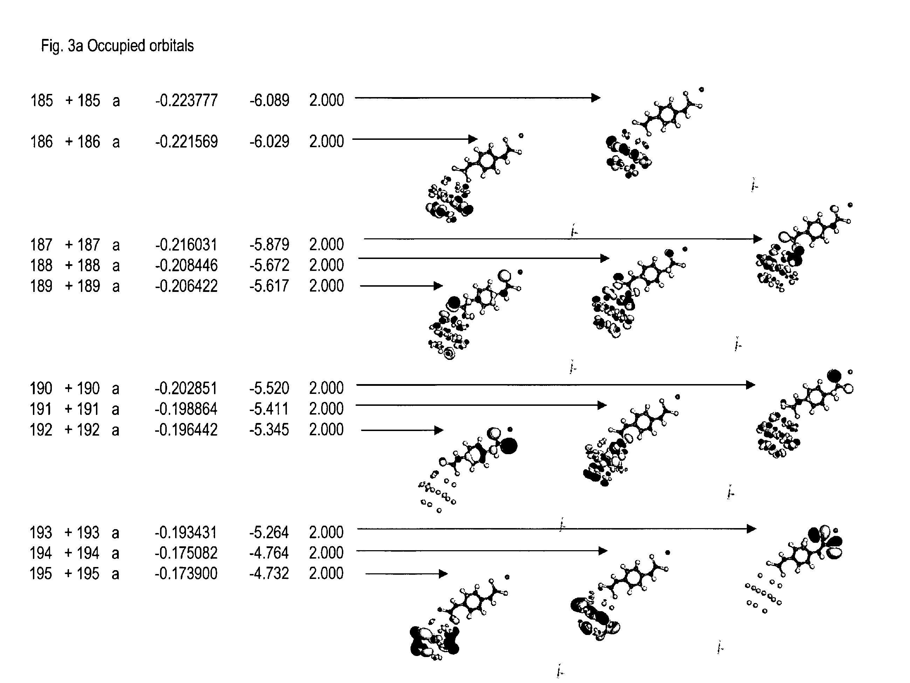

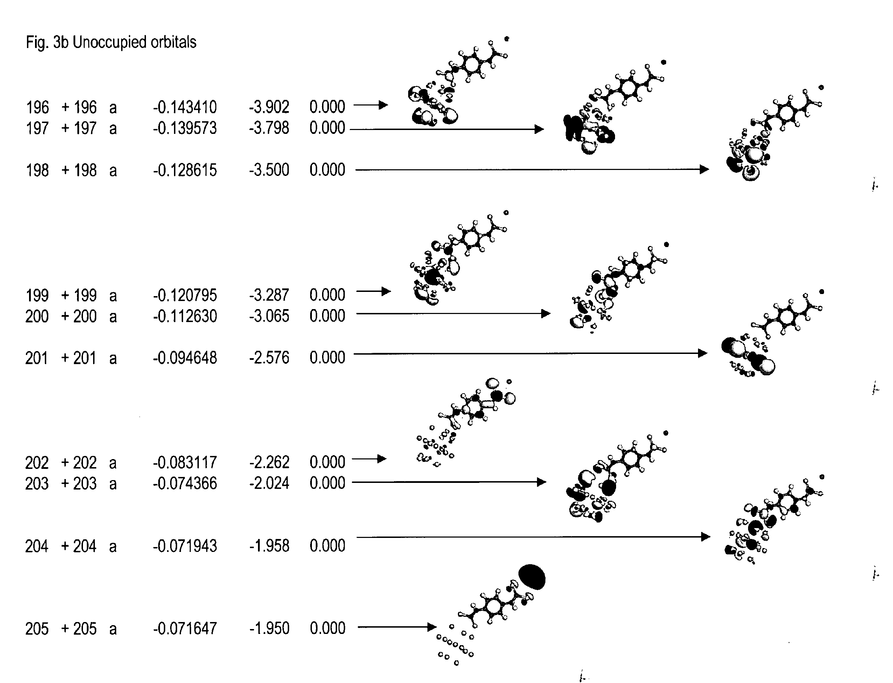

This situation is different if the molecule is attached via a dithiocarbamate group to the Au-cluster. Fig. 3a and 3b show the electron density of the first eight occupied and unoccupied molecular orbital energy levels, respectively, for a phenylene-bis-dithiocarbamate molecule coupled at one end to a Au₁₃ cluster. Most of the molecular orbitals around the Fermi energy show a delocalisation on both, the cluster and the dithiocarbamate moiety comprising both S atoms and the N atom. 0.5 eV below the Fermi level the HOMO-3 is fully delocalised over the whole molecule-cluster system. In contrast to the S-Au bond, these results show that the dithiocarbamate group provides an excellent coupling to Au, which has been experimentally demonstrated by Wessels et al. [24].

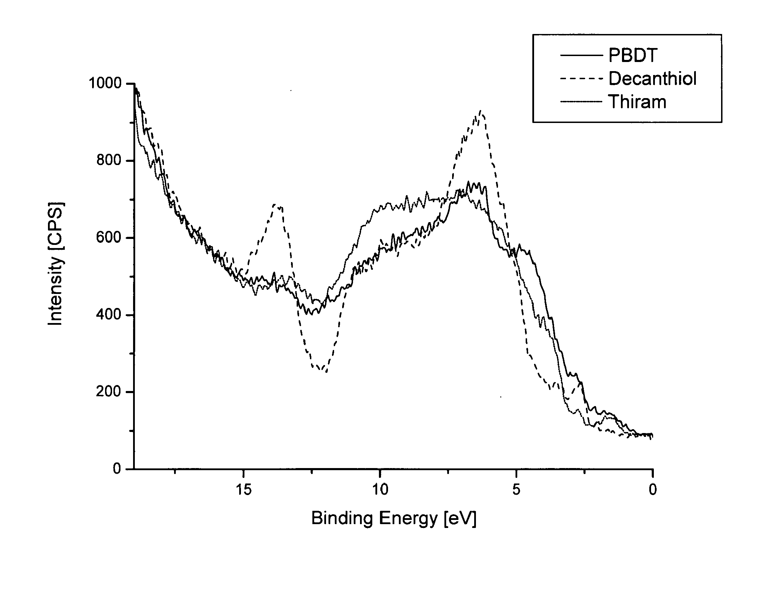

These findings are further supported by UPS spectra of self-assembled monolayers of thiol and dithiocarbamate derivatives on Au(111) (Figure 4). A pronounced difference in the intensities is observed when comparing thiol and dithiocarbamate derivatives. While decanethiol shows peaks at a binding energy of 6 eV and 14 eV, which are not apparent in the phenylene-bis-dithiocarbamate (PBDT) spectrum, a clear rise in the ultraviolet electron intensity of the PBDT is seen starting from about 1 eV below the Fermi energy and further peaks follow at 3 eV and 4.5 eV. The peaks between 3 and 5 eV overlap and lead to a broad increase of the intensity in this region. Decane thiol shows only a quite localized peak at about 2.8 eV. Between 2.8 eV and 5 eV the intensity is much lower than for PBDT. These UPS spectra provide experimental evidence for the existence of a high density of adsorbate states in the spectral region between 1 and 2 eV for dithiocarbamtes bound to Au. In case of PBDT bound to Au, a high density of adsorbate states can be additionally found in the spectral region between 2 eV and 5 eV.

XPS studies have shown that both S-atoms of the dithiocarbamate group bind equivalently to Au. The pronounced electron withdrawing capabilities of the C atom in the dithiocarbamate group probably facilitates the formation of the adsorbate state, providing the excellent electronic coupling between Au and the molecule. It is likely that this is also the case when the dithiocarbamate group binds to other metals such as Pd, Pt, Cu, Ni, and Ag.

### Example I. General structures of the molecular rectifiers

The molecular rectifiers that are proposed in the present invention preferably consist of a) mono-dithiocarbamate derivatives coupled to metal electrodes, and b) bis-dithiocarbamate derivatives coupled to metal electrodes having the general structure:

METAL₁-CON₁-BRIDGE-CON₂-METAL₂

where BRIDGE represents the core of the molecule, CON₁ and CON₂ denotes the connecting (coupling) groups, and METAL₁ and METAL₂ represent the metal electrodes. At least one of the connecting groups (CON₁ and CON₂) is a dithiocarbamate or derivative of a dithiocarbamate, and the metal comprising the electrodes (METAL₁ and METAL₂) may be the same or different.

The central BRIDGE itself can be further classified with respect to the position and number of pi-conjugated and non-conjugated parts:
(pi-conjugated)(non-conjugated)
(non-conjugated)(pi-conjugated)(non-conjugated)

Classification of the building blocks of the molecular rectifier proposed:
The combination BRIDGE-CON₂-METAL₂ in the general structure
METAL₁-CON₁-BRIDGE-CON₂-METAL₂ may be chosen from the following list:

| | |
|---|---|
| BRIDGE-NHCS₂-METAL₂ | (dithiocarbamate) |
| BRIDGE-NHC(SR)S-METAL₂ | (dithiocarbamate ester) |
| BRIDGE-NC(SR)₂-METAL₂ | (bis-dithiocarbonimidate) |
| BRIDGE-NR'CS₂-METAL₂ | (dithiocarbamate, N-substituted) |
| BRIDGE-NR'C(SR)S-METAL₂ | (dithiocarbamate ester, N-substituted) |
| BRIDGE-NH₂-METAL₂ | (amine) |
| BRIDGE-NC-METAL₂ | (isonitrile) |
| BRIDGE-NR'PS₃-METAL₂ | (trithiophosphoroamidate) |
| BRIDGE-S-METAL₂ | (thiolate) |
| BRIDGE-S(SR)-METAL₂ | (disulfide) |
| BRIDGE-SCS₂-METAL₂ | (trithiocarbonate) |
| BRIDGE-SC(SR)S-METAL₂ | (trithiocarbonate ester) |
| BRIDGE-CN-METAL₂ | (nitrile) |
| BRIDGE-CS₂-METAL₂ | (dithiocarboxylate) |
| BRIDGE-C(SR)S-METAL₂ | (dithiocarboxylate ester) |
| BRIDGE-COS-METAL₂ | (thiocarboxylate) |
| BRIDGE-COSR-METAL₂ | (thiocarboxylate ester) |
| BRIDGE-C₅H₄N-METAL₂ | (pyridine) |
| BRIDGE-C₃H₃N₂-METAL₂ | (imidazole) |
| BRIDGE-COO-METAL₂ | (carboxyate) |
| BRIDGE-OCS₂-METAL₂ | (xanthate) |
| BRIDGE-OC(SR)S-METAL₂ | (xanthate ester) |
| BRIDGE-OP(OR)S₂-METAL₂ | (dithiophosphate) |
| BRIDGE-OP(OR)(SR)S-METAL₂ | (dithiophosphate ester) |
| BRIDGE-PR₂-METAL₂ | (phosphine) |
| BRIDGE-PS₃-METAL₂ | (trithiophosphonate) |
| BRIDGE-P(SR)₂S-METAL₂ | (trithiophosphonate ester) |
| BRIDGE-Te-METAL₂ | (tellurate) |
| BRIDGE-Se-METAL₂ | (selenate) |

where discrete charges have been omitted, and the groups R or R' independently represent small organic residues such as methyl (CH₃), ethyl (CH₂CH₃), and phenyl (C₆H₅), and the like.

Conjugated building blocks: The following list of pi-conjugated systems comprises potential structural elements to be part of a molecular rectifier. The pi-conjugated systems may be further functionalized as described above. The structure is meant to be part of the molecular rectifier with the free sites attached to the molecular scaffold as indicated. Preferred examples are:

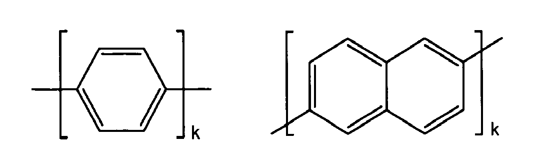

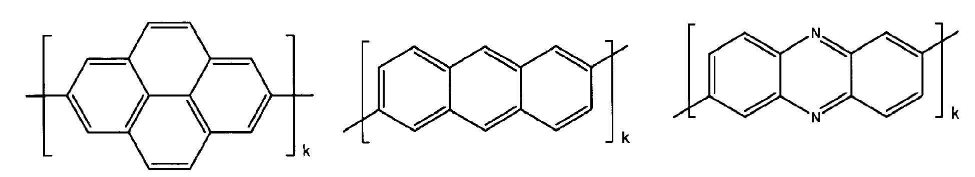

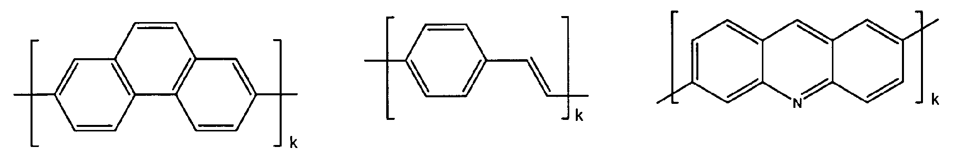

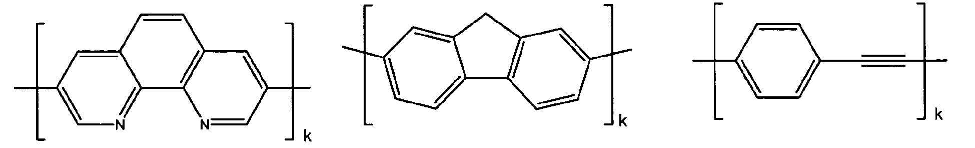

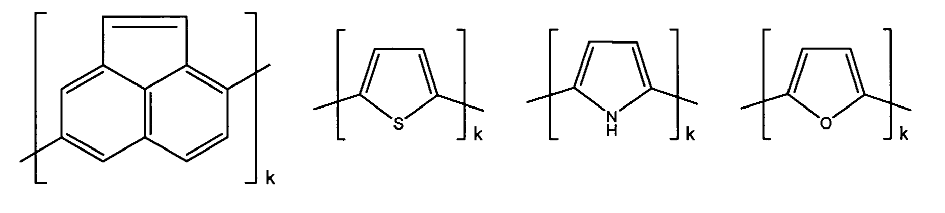

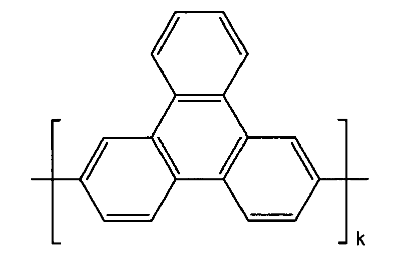

Non-conjugated building blocks: The non-conjugated moieties comprise aside from simple alkane chains [-(CH₂)-] cyclic and polycyclic aliphatic carbon skeletons which may be further functionalized as described above. The structure is meant to be part of the molecular rectifier with the free sites attached to the molecular scaffold as indicated.

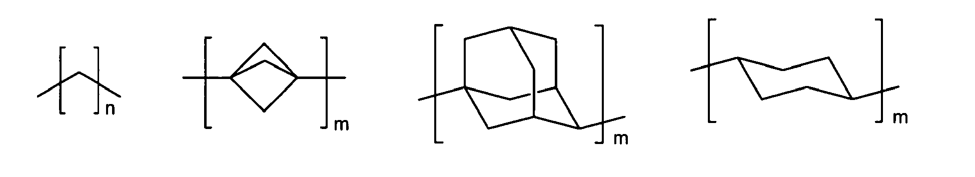

### Example II. Specific examples

### Mono-dithiocarbamate derivatives

a1) One of the metal coupling groups is a dithiocarbamate derivative BRIDGE-NHCS₂₋METAL or BRIDGE-NRCS₂-METAL attached to the conjugated moiety (BRIDGE). The other moieties of the molecule may be chosen from the said building block lists. The molecular rectifier has the following general structure:

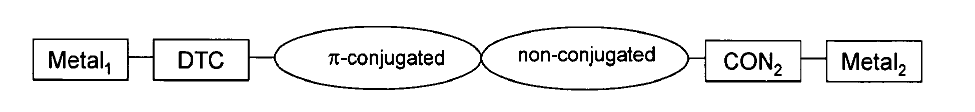

The rectifiers proposed possess a constitutionally inherent asymmetry due to the combination of pi-conjugated and non-conjugated bridge and different metal binding groups.

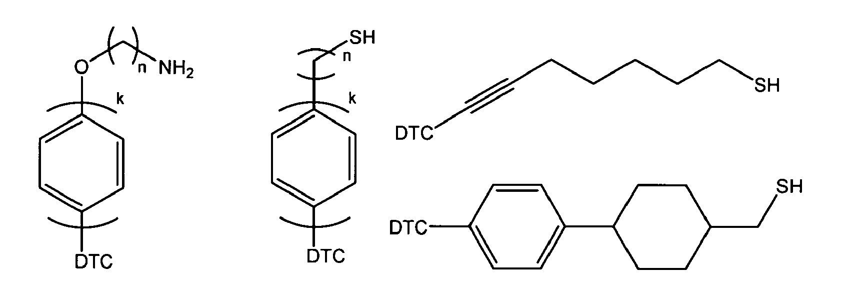

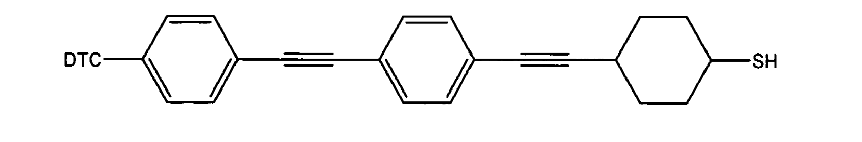

a2) One of the metal coupling groups is a dithiocarbamate derivative BRIDGE-NHCS₂₋METAL or BRIDGE-NRCS₂-METAL attached to the non-conjugated moiety (BRIDGE). The other moieties of the molecule may be chosen from the said building block lists. The molecular rectifier has the following general structure:

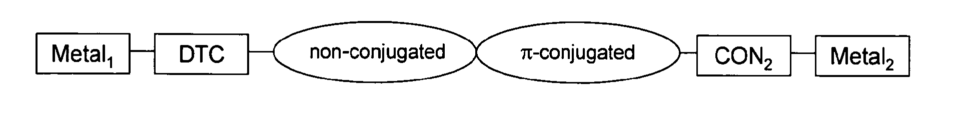

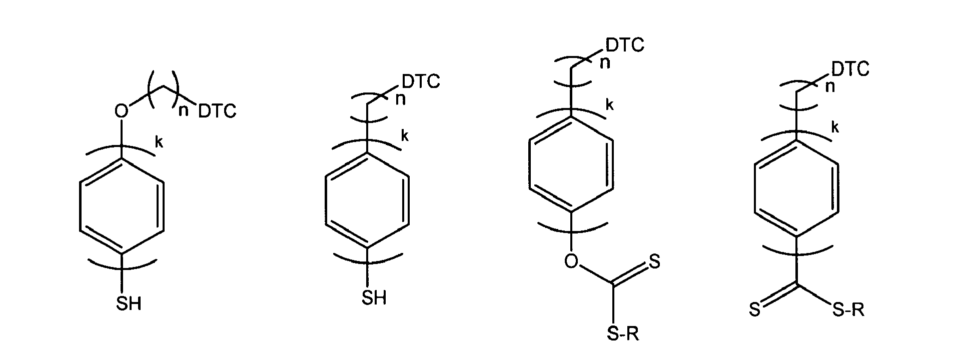

a3) One of the metal coupling groups is a dithiocarbamate derivative BRIDGE-NHCS₂₋METAL or BRIDGE-NRCS₂-METAL attached to the non-conjugated moiety (BRIDGE). The other moieties of the molecule may be chosen from the said building block lists. The pi-conjugated part is placed in between two non-conjugated, resistive parts. The molecular rectifier has the following general structure:

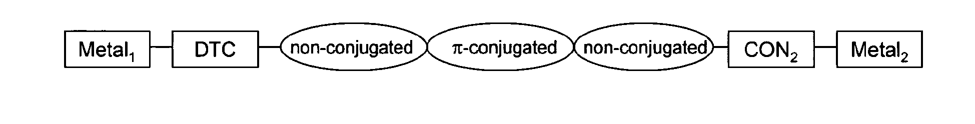

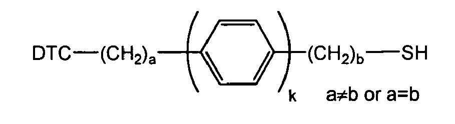

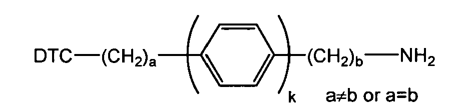

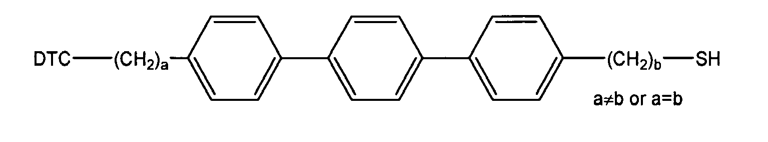

### Bis-dithiocarbamate derivatives

b1) Both of the metal coupling groups are a dithiocarbamate derivative BRIDGE-NHCS₂₋METAL or BRIDGE-NRCS₂-METAL attached to the conjugated moiety (BRIDGE). The other moieties of the molecule (pi-conjugated and non-conjugated part) may be chosen from the said building block lists. The molecular rectifier has the following general structure:

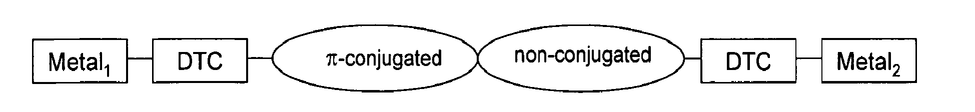

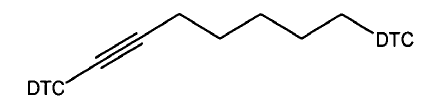

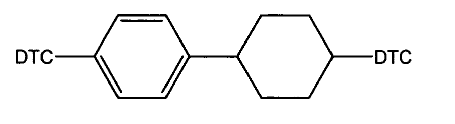

b2) Both of the metal coupling groups are a dithiocarbamate derivative BRIDGE-NHCS₂₋METAL or BRIDGE-NRCS₂-METAL attached to the non-conjugated moiety (BRIDGE).

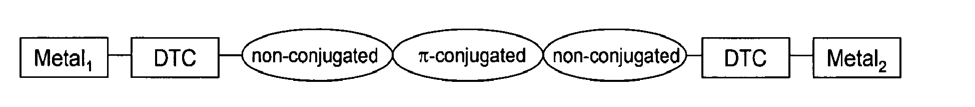

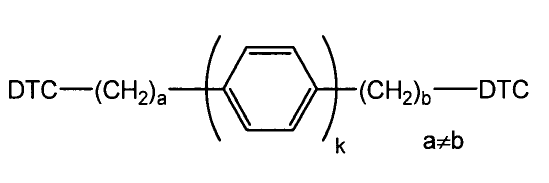

A difference in length between the non-conjugated parts will be sufficient for a rectifying behavior. For the following selected molecular rectifiers the orbital of the molecules and/or molecule-cluster conjugates have been calculated.

### 1) Molecular rectifiers having the general structure

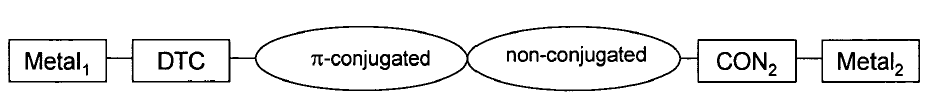

consisting of one dithiocarbamate binding group and one amine binding group,

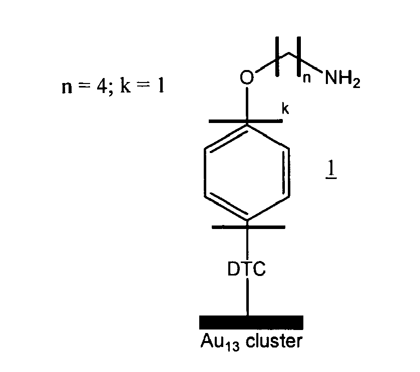

### and 2) one dithiocarbamate binding group and one thiol binding group,

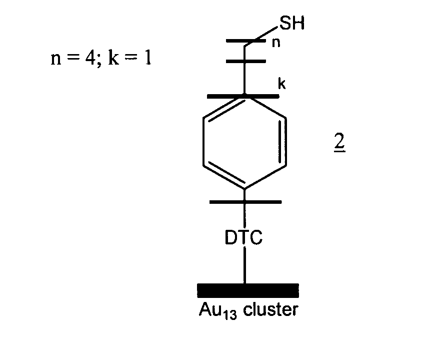

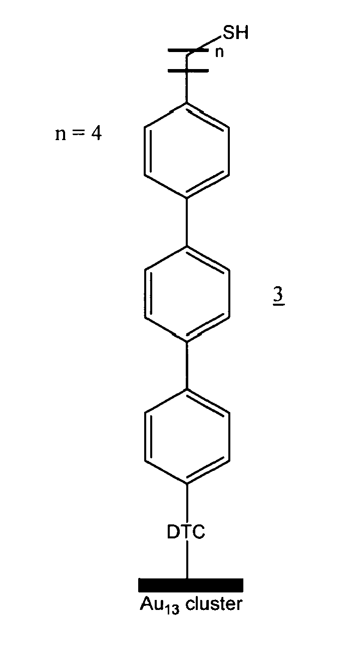

Figure 4 a and b show the electron density of the first five occupied and five unoccupied molecular orbital energy levels, respectively, for molecule 1 coupled with the dithiocarbamate end to a Au₁₃ cluster. The occupied orbitals are mainly delocalised over the Au cluster and the S atoms of the dithiocarbamate binding group. Roughly 0.7 eV above the Fermi level the orbitals are delocalised over the Au-cluster and the pi-conjugated part of the molecule including the O atom attached in para position to the benzene ring. Similarly, in case of the unoccupied orbitals the orbital are mainly delocalised over the Au-cluster and the whole dithiocarbamate group. The LUMO+3 and LUMO+4 orbitals also show a small contribution on the benzene ring and the O atom.

Figure 5 shows the electron density of the first eleven occupied (5a) and nine unoccupied (5b) molecular orbital energy levels for molecule 2 with a Au₁₃ cluster attached to the dithiocarbamate group, respectively. Except for HOMO+6 where the orbitals are localized on the thiol group, the electron density is delocalised on the Au-cluster and the dithiocarbamate binding group. The orbital that lays 0.501 eV below the HOMO is delocalised over the Au-cluster, the binding group and the benzene ring. Similarly, the unoccupied orbitals are delocalised over the Au-cluster and the binding group. The delocalization extends to the benzene ring for LUMO+4.

Although one of the metal binding group and the length of the alkane chain is different for these two molecules, these examples indicate that the O atom attached in para position to a benzene ring that is substituted in the other para position with a dithiocarbamate group has a pronounced effect on the orbitals that are delocalised over the Au cluster, the dithiocarbamate binding group and the benzene ring. The electron density on the benzene ring is in case of molecule 1 not as pronounced as in the case of molecule 2.

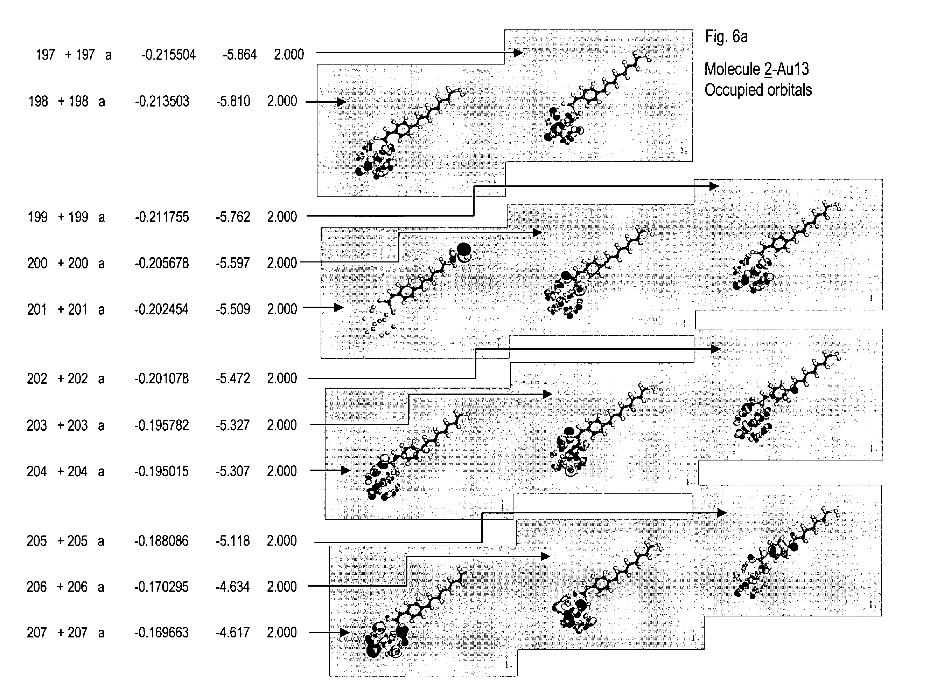

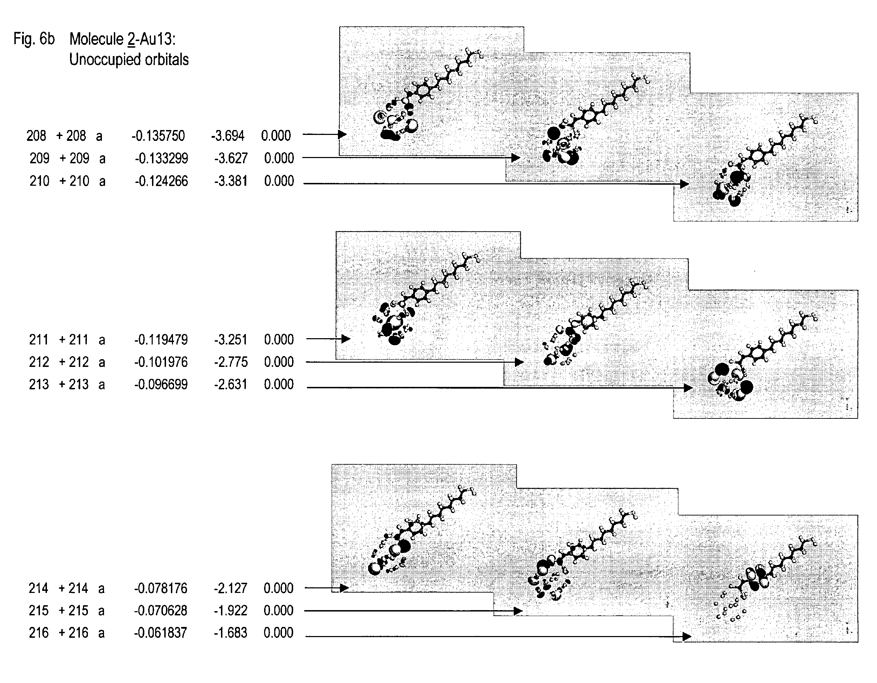

Figure 6 shows the electron density of the first six occupied and six unoccupied molecular orbital energy levels for molecule 3 with a Au₁₃ cluster attached to the dithiocarbamate group (6a and b) and attached to the thiol group (6c and d), respectively. If the Au-cluster is attached to the dithiocarbamate group (Fig 6a and b), the calculated molecular orbitals show characteristics that are comparable with molecule 2. However, the first occupied orbital, which is delocalised over the cluster and the pi-conjugated part of the molecule, lays 0.572 eV below the HOMO. Thus an extension of the molecular electron system when attached via a dithiocarbamate binding group to a Au cluster leads to an increase in the energy gap between the HOMO and the orbital which is delocalised over the cluster and the phenyl ring system. It is further pertinent to know that the HOMO-LUMO gap is also slightly larger. In case the Au cluster is attached to the thiol group, the first three occupied molecular orbitals, which are almost degenerate are either located on the dithiocarbamate group or on the Au cluster (Fig 6c). This indicates that the dithiocarbamate group provides energy levels close to the Fermi level of the Au cluster. Only 0.199 eV above the HOMO lays the first orbital, which is delocalised over the ring system and the dithiocarbamate binding group. The first five unoccupied molecular orbitals are all associated mainly with the Au cluster with a small contribution from the *p*-orbital of the S binding group.

### 3) Molecular rectifiers having the general structure

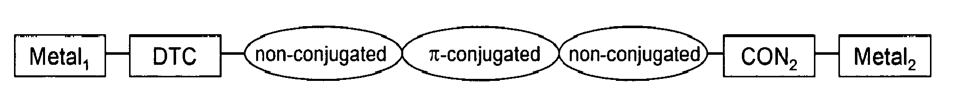

consisting of one dithiocarbamate binding group and one thiol binding group, 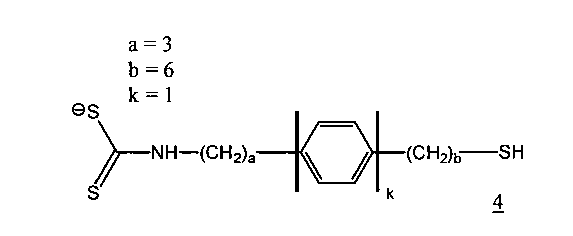 and consisting of two dithiocarbamate binding groups.

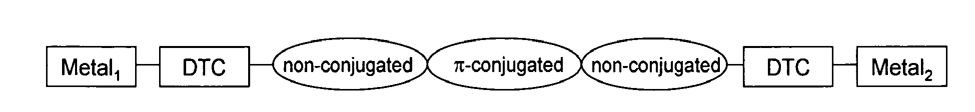

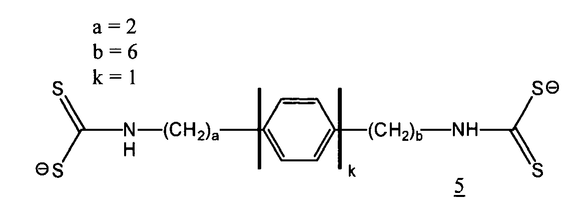

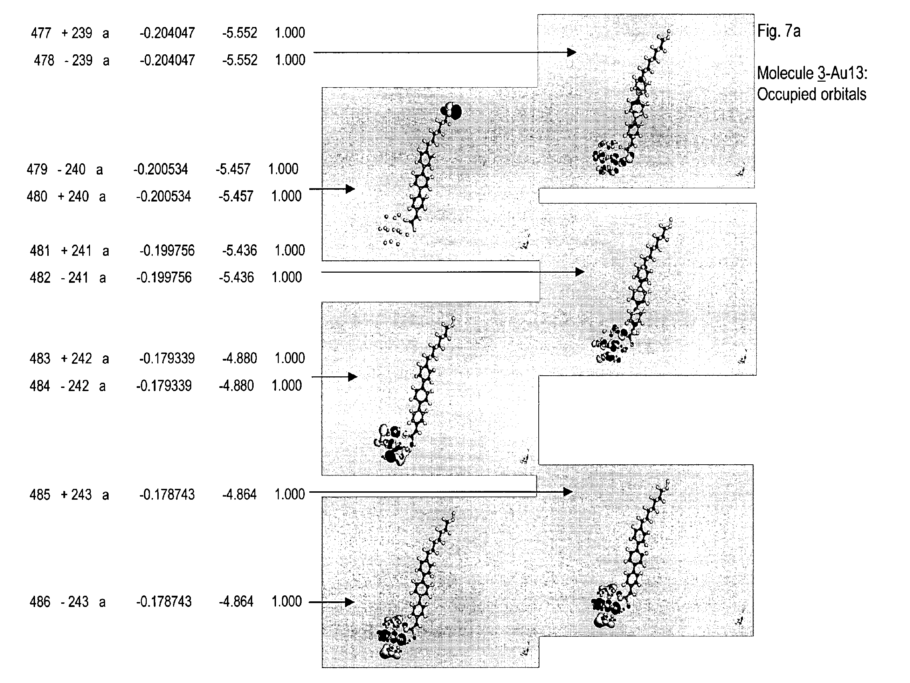

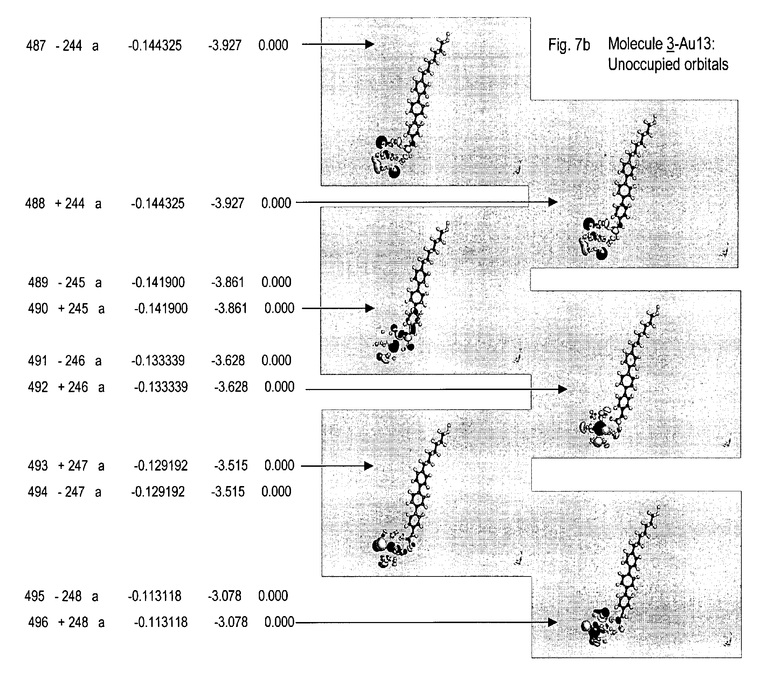

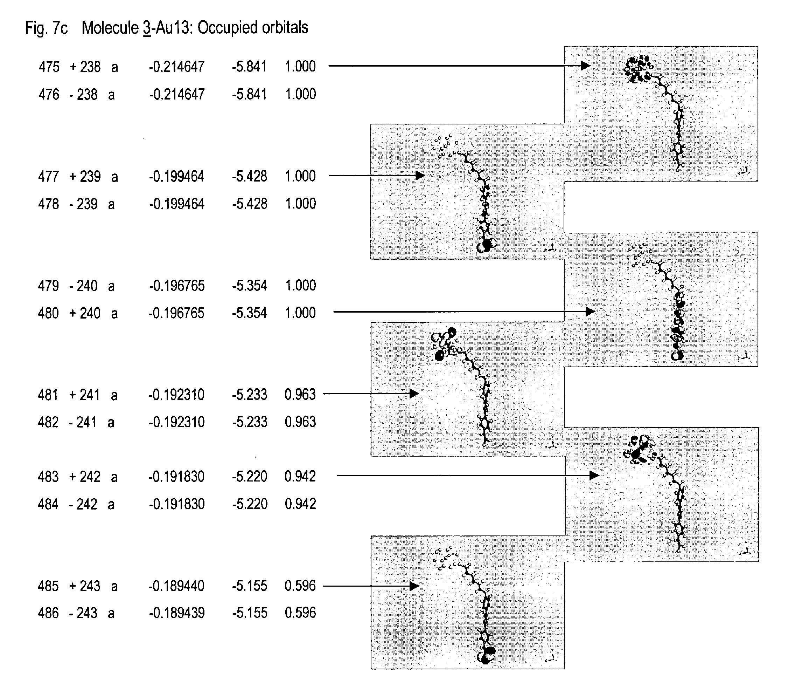

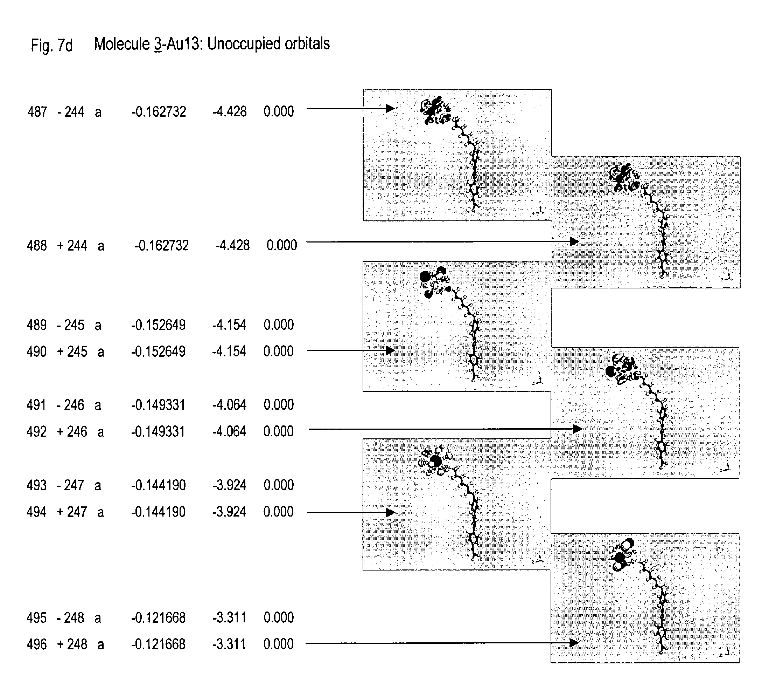

Figure 7 shows the electron density of the first seven occupied and five unoccupied molecular orbital energy levels of molecule 4. The first two occupied orbitals are localized on the benzene ring with a small contribution on the amine group that is directly attached to the benzene ring. The following four occupied orbitals are localized on the metal binding groups. A clear separation of electron density on the conjugated core and on the metal binding groups is also apparent in the unoccupied orbitals. However, the first unoccupied orbitals are located on the dithiocarbamate groups, while the orbitals that are high in energy are located on the benzene core. The HOMO-LUMO gap is only 0.421 eV.

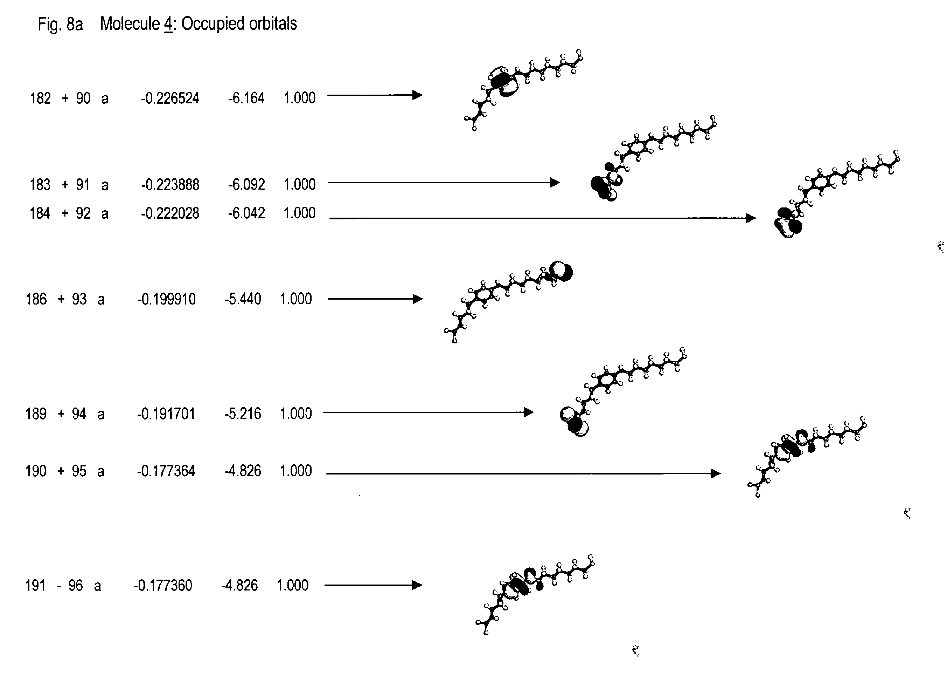

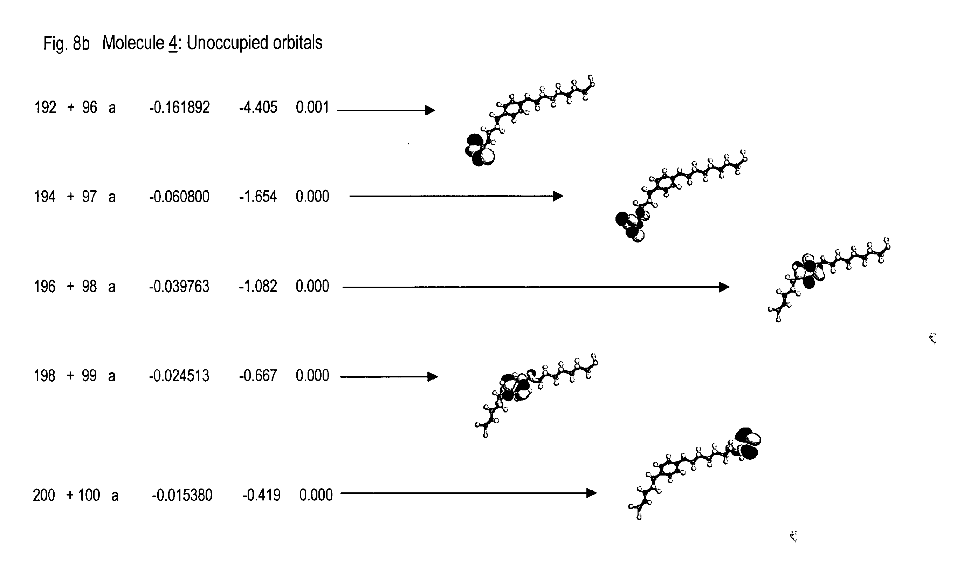

Figure 8 shows the occupied and unoccupied molecular orbitals for molecule 5 without a Au cluster attached to any of the connecting groups. The first occupied molecular orbital are located on the bis-dithiocarbamate binding groups. Roughly 1.1 eV above the HOMO, the orbital is delocalised over the dithiocarbamate group end the conjugated part of the molecule.

### Example III. Directed assembly via sequential deprotection

Oriented assembly via sequential deprotection of metal binding groups. An oriented assembly of the devised structures can be achieved by employing the technique of orthogonal protecting groups for the metal binding groups, i.e. the use of different protecting groups for both ends of the rectifying molecule. Employing orthogonal protecting groups for the metal binding groups means that one metal binding group can be selectively deprotected after each other and exposed to the metal by using different deprotection conditions.

An example is the assembly of molecules containing a dithiocarbamate ester or derivative and a thiol protected via the trimethylsilylethyl group (TMSE). After the assembly of molecules facing with the dithiocarbamate ester to the metal the TMSE can be removed by exposition to tetrabutylammonium fluoride in THF.

With respect to the vast number of protecting groups available for thiols and other metal binding groups it is referred to the literature [25].

### Example IV. Chemical modification after SAM formation.

This section specifically addresses the fabrication of molecular rectifiers in which the connecting groups CON₁ and CON₂ have similar metal-binding affinities, such as when both are dithiocarbamate derivatives. It can be anticipated that molecules having the general structure CON₁-BRIDGE-CON₂ will assemble onto a metal surface with no preferred orientation, since the binding affinities of the two ends are essentially the same, thereby negating the intrinsic rectifying properties of the individual molecules.

One way to circumvent this problem is to introduce interacting side groups into the molecules to promote a particular orientation during adsorption onto the metal surface. However, this approach has several drawbacks, including increased synthetic requirements and potentially complicated electronic effects.

An alternative approach to circumventing this problem is chemical modification after SAM formation. Specifically, molecules having the general structure DTC-BRIDGE-NH₂, in which DTC represents a dithiocarbamate derivative, are expected to assemble preferentially onto metal surfaces with the orientation METAL₁-DTC-BRIDGE-NH₂ instead of METAL₁-NH₂₋BRIDGE-DTC due to the significantly greater metal-binding energy of dithiocarbamates compared to amines.

Previous work has demonstrated that SAMs of thiols on gold surfaces are robust enough to sustain chemical modification after assembly. Examples include the activation of terminal carboxylic acid groups of SAMs of 11-mercaptoundecanoic acid and subsequent reaction with amines or alcohols to form amide or ester linkages and involve exposing the SAMs to various kinds of organic solvents and reagents. The conversion of the amine group to the dithiocarbamate group (salt or ester derivative), which proceeds in a straightforward manner in the solution phase, is likewise expected to occur in the METAL₁-DTC-BRIDGE-NH₂ assembly by exposing it to the appropriate reagents, making it possible to fabricate METAL₁-DTC-BRIDGE-DTC-METAL₂ assemblies in which the BRIDGE units have a single, preferred orientation.

### Example V. Synthesis of a molecular rectifier via chemical modification of a SAM

This procedure is based on one that was described by Rosink *et al.* [26]. They demonstrated the self-assembly of pi-conjugated azomethine oligomers by sequential deposition of monomers from solution, and found that the azomethine molecules order approximately perpendicular to the gold surface. The process starts with the growth of a monolayer of 4-aminothiophenol (4-ATP) from solution phase onto a gold substrate. The thiol group of 4-ATP binds covalently to the gold surface, so that the molecules in the resulting SAM are oriented with the amine groups free for subsequent chemical reaction. In the second step of the process, the SAM is treated with a solution of 1,4-diformylbenzene (terephthaldicarboxaldehyde, TDA). One of the aldehyde groups of TDA condenses with the amine group of 4-ATP in the SAM to form a pi-conjugated imine bond between the two aromatic rings, which is terminated by the unreacted aldehyde group of the TDA moiety. The third step of the process involves the condensation reaction of one of the amine groups of 1,4-diaminobenzene (DAB) with the unreacted aldehyde group of the TDA moiety, extending the degree of pi-conjugation by forming another imine bond.

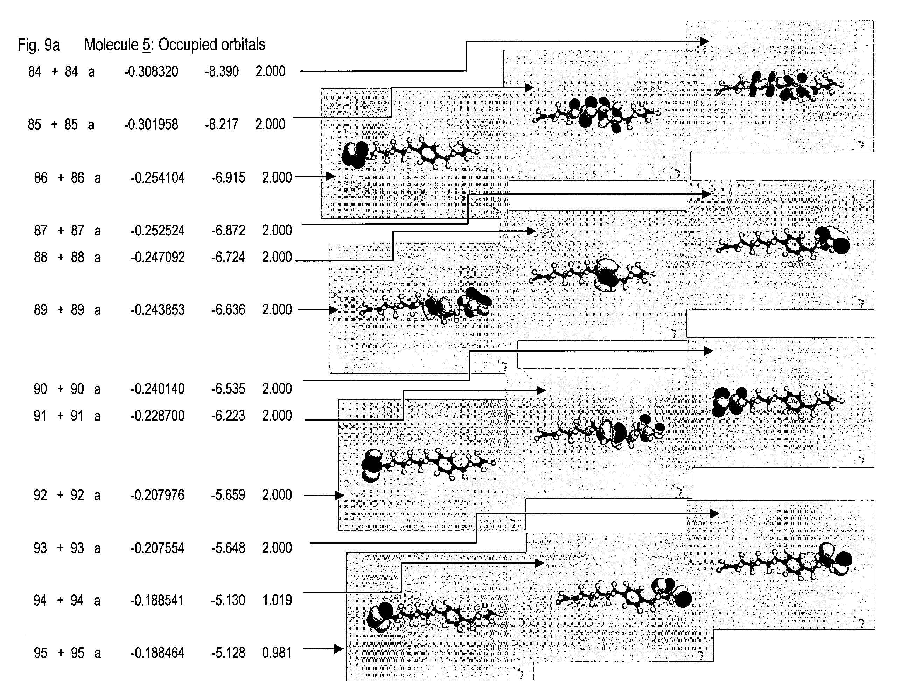

The procedure of Rosink *et al* is modified in this example to provide a molecular rectifying assembly. The first two steps of the process are the same as they described, i.e., the formation of a SAM of 4-ATP on a gold surface and reaction of the SAM with TDA. The structure 6 of the resulting SAM after these two steps is shown in Figure 9. This structure provides the METAL₁-CON₁-(pi-conjugated) half of a molecular rectifying assembly. In order to provide the non-conjugated part, 1,4-diaminocyclohexane (DAC) is used instead of DAB in the third step. As indicated in Figure 9, the structure 7 of the SAM after the third step has a free amine group that is converted in the fourth step to a DTC group, in this case a dithiocarbamate salt 8. The dithiocarbamate end of the molecule is finally contacted to a second metal in the fifth step, to provide a METAL₁-CON₁-(pi-conjugated)(non-conjugated)-CON₂-METAL₂ rectifying assembly, wherein -CON₁- is -S- and -CON₂- is -DTC-.

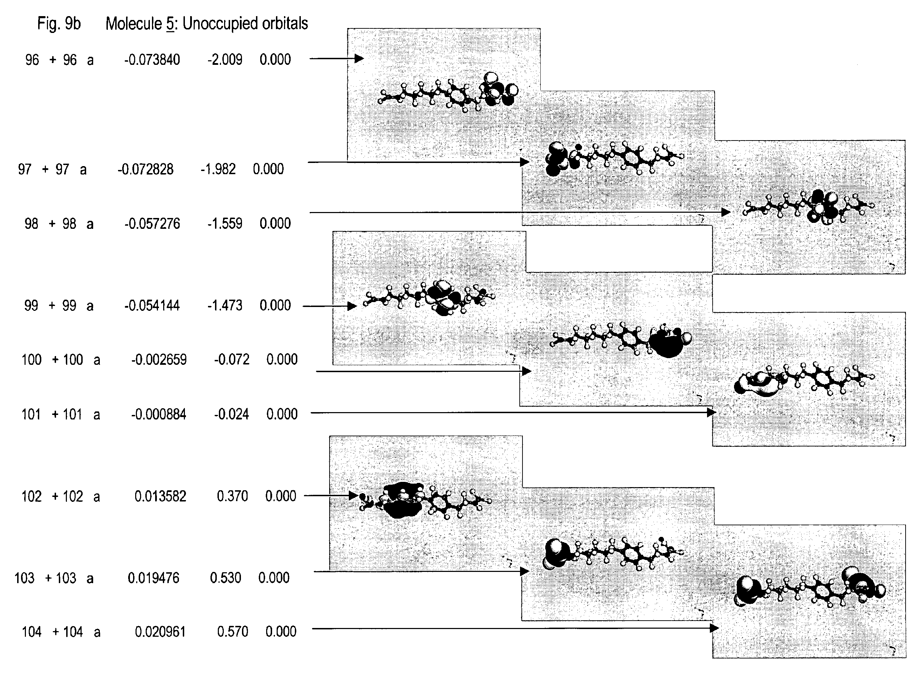

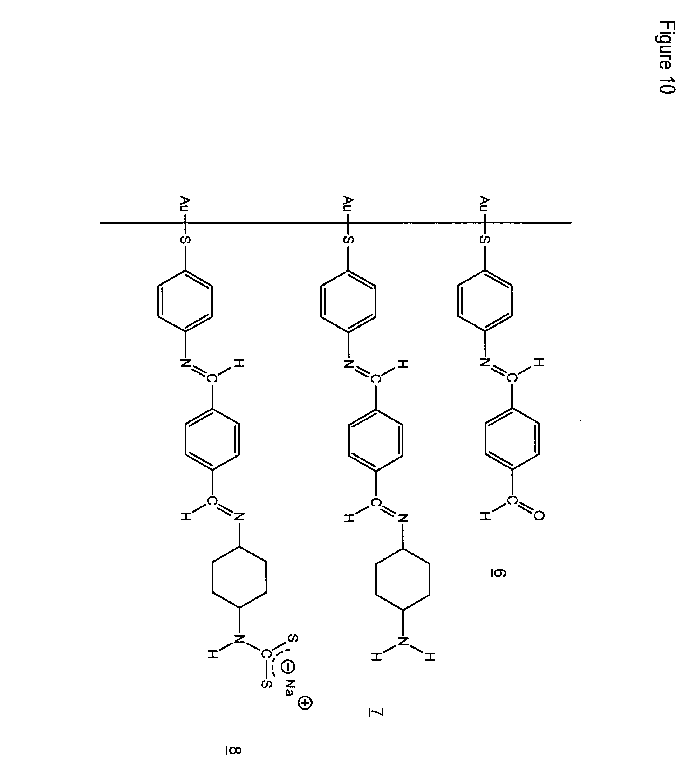

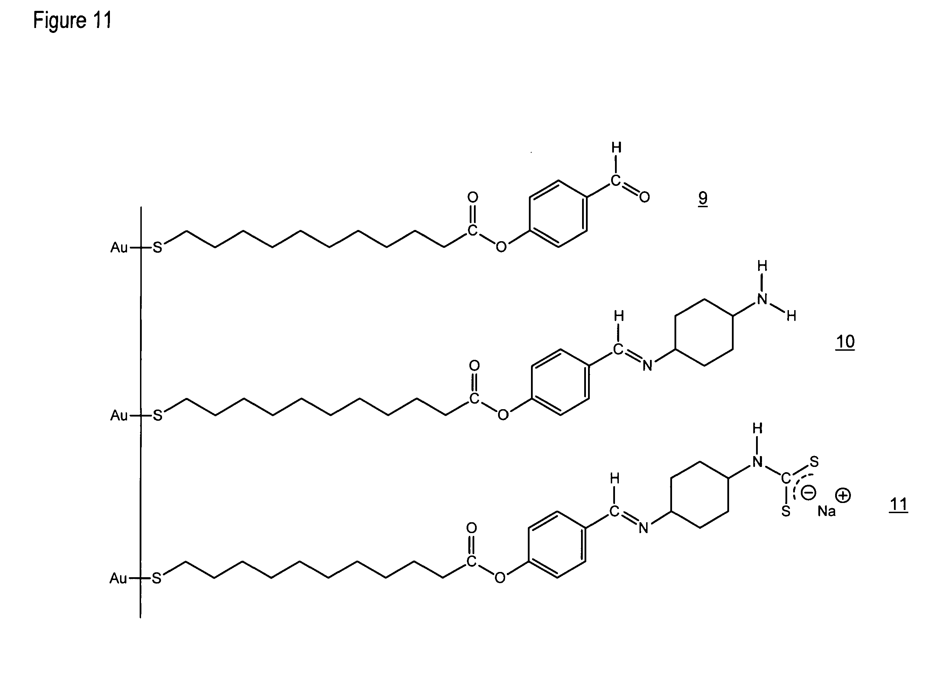

Similar segment by segment growth strategies can be used to provide examples of METAL₁₋CON₁-(non-conjugated)(pi-conjugated)(non-conjugated)-CON₂-METAL₂ and METAL₁₋CON₁-(non-conjugated)(pi-conjugated)-CON₂-METAL₂ rectifying assemblies, as indicated in Figure 10 and Figure 11, respectively. First a SAM is formed from molecule 9 on a gold surface (Figure 10). Molecule 9 is synthesized from 11-mercaptoundecanoic acid and 4-hydroxybenzaldehyde. Condensation of the aldehyde group in the SAM of 9 with DAC yields 10, and the amine group in the SAM of 10 is converted to the dithiocarbamate salt 11 through reaction with CS₂ and NaOH. Alternatively, the aldehyde group in the SAM of 9 with is condensed with DAB to yield 12, and the amine group in the SAM of 12 is converted to the dithiocarbamate salt 13 through reaction with CS₂ and NaOH (Figure 11). The SAMs of 11 or 13 are finally contacted to a second metal to provide METAL₁-CON₁-(non-conjugated)(pi-conjugated)(non-conjugated)-CON₂-METAL₂ or METAL₁-CON₁-(non-conjugated)(pi-conjugated)-CON₂-METAL₂ rectifying assemblies, wherein -CON₁- is -S- and -CON₂- is - DTC-.

### Example VI. Synthesis of methyl 4-(2-aminoethoxy)phenylcarbamodithioate hydrochloride

A rectifier with a dithiocarbamate ester group as connecting group 1 (CON₁) and an amino group as connecting group 2 (CON₂) has been synthesized according to the following scheme: 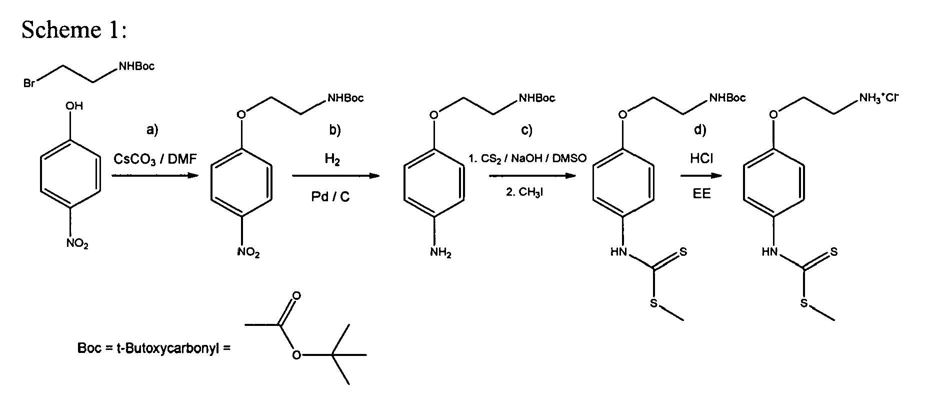
a,b) Williamson etherification and reduction of nitro group (standard procedures)
c) Preparation of dithiocarbamate ester (standard procedure) [27]
d) Deprotection of amino group [28]. 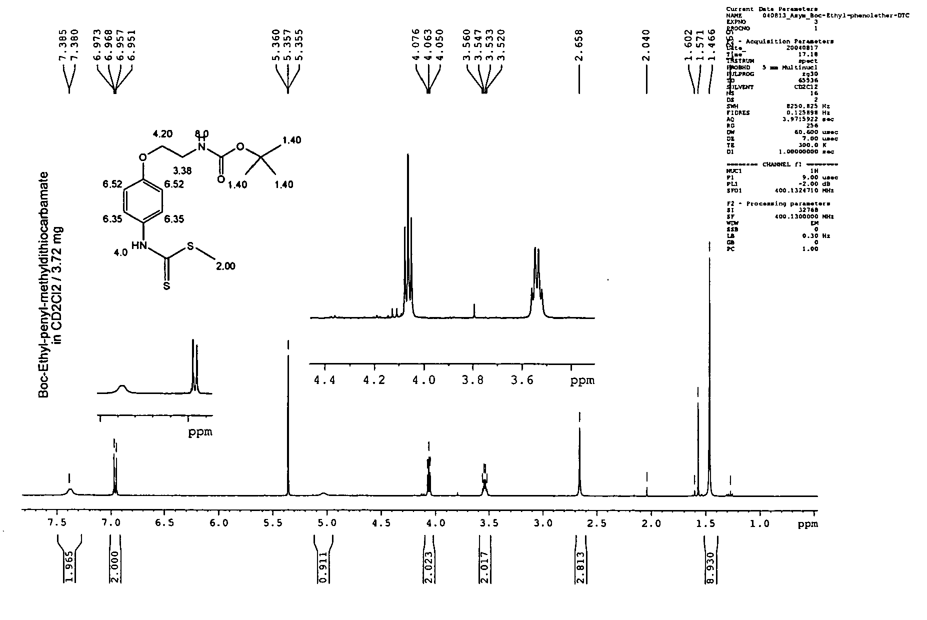 ¹H-NMR (400 MHz, CD₂Cl₂) spectrum of intermediate isolated after reaction step c). The spectrum matches the devised structure (inset) which is further supported by the elemental analysis (C, 52.69; H, 6.59; N, 8.26; O, 14.3; S, 18.4 / calcd. C, 52.61; H, 6.47; N, 8.18; O, 14.02; S, 18.73) [29].

The synthesis of the target compound as hydrochloride proceeds smoothly with 3M HCl in ethyl acetate at room temperature. Yield is about 200 mg (99%) without the need of any further purification. The free base can be formed by treating the hydrochloride with 1N NaOH and extracting the amine into chloroform or ether. 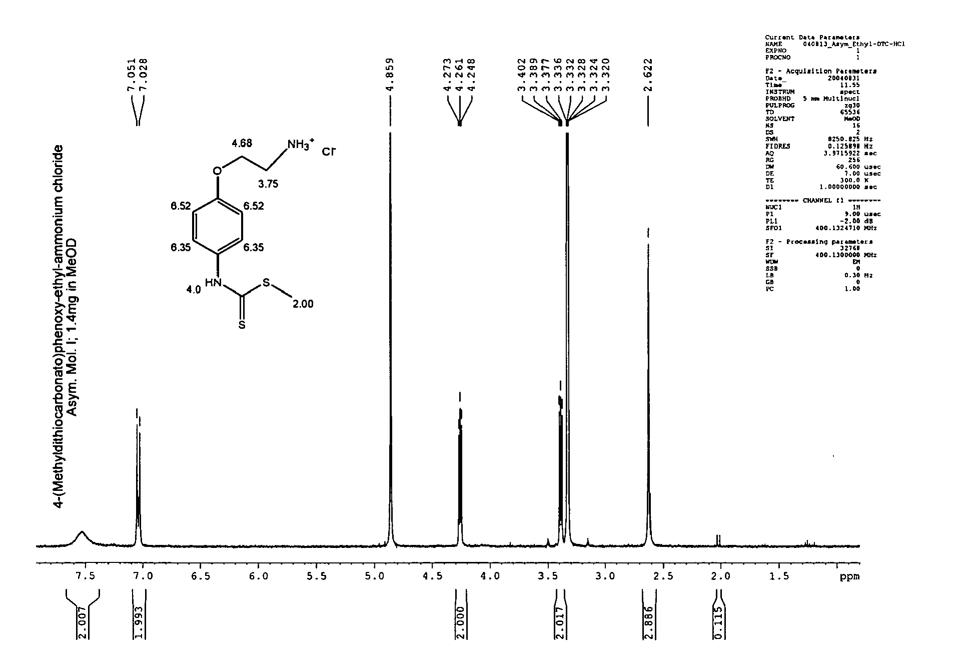 ¹H-NMR (400 MHz, MeOD) spectrum of the target compound methyl 4-(2-aminoethoxy)phenylcarbamodithioate hydrochloride isolated after reaction step d). The spectrum matches the devised structure (inset).

The procedure allows easily for the attachment of longer alkyl chains to the phenoxy-subunit. Optionally the attachment of an alkyl chain can be carried out via a Mitsunobu-type reaction according to Quéléver et. al. [30].

The features disclosed in the foregoing description, in the claims and/or in the accompanying drawings may, both separately and in any combination thereof, be material for realizing the invention in diverse forms thereof.

### References

1. A. Aviram and M.A: Ratner, *Chem. Phys. Lett.* **1974,** 29, 277.
2. E. Humeres, N.A. Debacher, M. M. de S. Sierra, *J. Org. Chem.* **1999, 64, 1807.**
3. A. Ariafard, M.M. Amini, R. Fazaeli, H. R. Aghabozorg, *J. Mol. Structure (Theo-chem)* **2004,** 672, 141.
4. M. Di Ventra, N.D. Lang, *Phys. Rev. B* **2001,** *65,* 045402.
5. J.G. Kushmerick, C.M. Whitaker, S.K. Pollack, T.L. Schull, R. Shashidhar, *Nanotechnology* **2004,** 15, S489.
6. S. Hong, R. Reifenberger, W. Tian, S. Datta, J. Henderson, C.P. Kubiak, *Superlattices and Microstructures* **2000, 28, 289.**
7. J.M. Semenario, C.E. De La Cruz, P.A. Derosa, *J. Am. Chem. Soc.* **2001,** *123,* 5616.
8. M.Di Ventra, S.T. Pantelides, N.D. Lang, *Phys.Rev. Lett.* **2000**, 5, 979.
9. R.M. Metzger, *Acc. Chem. Res. 1999, 32, 950.*
10. M.L. Chabinyc, X. Chen, R.E. Holmlin, H. Jacobs, G.M. Skulason, C.D. Frisbie, V. Mujica, M.A. Ratner, M.A. Rampi, G.M. Whitesides, *J. Am. Chem. Soc.* **2002,** *124,* 11862.
11. S.K. Pollack, J. Naciri, J. Mastrangelo, C.H. Patterson, J. Torres, M. Moore, R. Sahidhar, J.G. Kushmerick, *Langmuir* **2004**, *20,* 1838.
12. J.C. Ellenbogen and J.C. Love, *Proc. IEEE* **2000,** 88, 386.
13. G.J. Ashwell, J.R. Sambles, A.S. Martin, W.G. Parker, M.J. Szablewski, *J. Chem. Soc. Chem. Commun.* **1990**, 1374.
14. A.S. Martin, J.R. Sambles, G.J. Ashwell, *Phys. Rev. Lett.* **1993,** *70*, 218.
15. R.M. Metzger, B. Chen, U. Hopfner, M.V. Lakshmikantham, D. Vuillaume, T. Kawai, X. Wu, H. Tachibana, T.V. Hughes, H. Sakurai, J.W. Baldwin, C. Hosch, M.P. Cava, L. Brehmer, G.J. Ashwell, *J. Am. Chem. Soc.* **1997**, *119*, 10455.
16. D. Vuillaume, B. Chen, R.M. Metzger, *J. Phys. Chem. B* **1999**, *103*, 447.
17. D. Vuillaume, B. Chen, R.M. Metzger, *Langmuir* **1999**, *15,* 4011.
18. C. Krzeminski, C. Delerue, G. Allan, D. Vuillaume, R.M. Metzger, *Phys. Rev. B* **2001,** 64, 086405.
19. P.E. Kornilovitch, A.M. Bratkovsky, R.S. Williams, *Phys. Rev. B* **2002**, *66*, 165436.
20. C. Boulas, J.V. Davidovits, F. Rondelez, D. Vuillaume, *Phys. Rev. Lett.,* **1996,** 76, 4797.
21. A.W. Gosh, F. Zahid, P.S. Damle, S.Datta, cond-mat/0202519 (unpublished).
22. J. Reichert, R. Ochs, D. Beckmann, H.W. Weber, M. Mayor, H. v Löhneysen, *Phys. Rev. Lett.* **2002**, 88, 176804.
23. Tuned multifunctional linker molecules for electronic charge transport through organic-inorganic composite structures and use thereof, EP 1 125 205 A1.
24. J.M. Wessels, H.G. Nothofer, W.E. Ford, F. Von Wrochem, T. Vossmeyer, A. Schroedter, H. Weller, A. Yasuda, *J. Am. Chem. Soc.* **2004,** *124,* 11862.
25. T.W. Greene, P.G.M. Wuts, *Protective groups in organic synthesis.*
26. J.J.W.M. Rosink, M.A. Blauw, L.J. Geerligs, E. van der Drift, B.A.C. Rousseeuw, S. Radelaar, W.G. Stoof, E.J.M. Fakkeldij, *Langmuir **2000**, 16, 4547.*
27. J. Garin, E. Meléndez, F. L. Merchán, P. Merino, T. Tejero, *Bull. Soc. Chim. Belg.* 1988, 97, 791.
28. G. L. Stahl, R. Walter, C. W. Smith, *J. Org. Chem.* **1978**, *43,* 2285.
29. Mikroanalytisches Labor Pascher, An der Pulvermühle 1, D-53424 Remagen-Bandorf (Germany).
30. G. Quéléver, F. Bihel, J.-L. Kraus, *Org. Biomol. Chem.* **2003,** *1*, 1676.

## Claims

1. Molecular rectifying assembly, comprising the general structure
METAL₁-CON₁-BRIDGE-CON₂-METAL₂
in which
CON₁ and CON₂ are a connecting group or connecting part and independently of each other are molecular groups bound to METAL_{1,2} in such a way that an adsorbate state with an energy close to the Fermi energy of the metal is formed at one or both of the METAL_{1,2}/CON_{1,2} interfaces,
METAL is selected from metals and/or alloys of metals, and
BRIDGE is the core of the molecule, consisting of pi-conjugated and non-conjugated parts.

2. Molecular rectifying assembly according to claim 1, wherein CON₁ and CON₂ independently are identical or different.

3. Molecular rectifying assembly according to claim 1 or 2, wherein the metal is selected from the group comprising Au, Ag, Pd, Pt, Cr, Cu, Ti, Ni, and combinations of these metals, and alloys thereof.

4. Molecular rectifying assembly according to claim 3, wherein the metals independently are the same or different.

5. Molecular rectifying assembly according to any of claim 1 to 4, wherein in BRIDGE-CON-METAL the group -CON- is selected from -NHCS₂- (dithiocarbamate); -NHC(SR)S- (dithiocarbamate ester); -NC(SR)₂- (bis-dithiocarbonimidate); -NR'CS₂- (dithiocarbamate, N-substituted); -NR'C(SR)S- (dithiocarbamate ester, N-substituted); -NH₂- (amine); -NC- (isonitrile); -NR'PS₃- (trithiophosphoroamidate); -S- (thiolate); -S(SR)- (disulfide); -SCS₂- (trithiocarbonate); -SC(SR)S- (trithiocarbonate ester); -CN- (nitrile); -CS₂- (dithiocarboxylate); - C(SR)S- (dithiocarboxylate ester); -COS- (thiocarboxylate); -COSR- (thiocarboxylate ester); - C₅H₄N- (pyridine); -C₃H₃N₂- (imidazole); -COO- (carboxylate); -OCS₂- (xanthate); - OC(SR)S- (xanthate ester); -OP(OR)S₂- (dithiophosphate); -OP(OR)(SR')S- (dithiophosphate ester); -PR₂- (phosphine); -PS₃- (trithiophosphonate);-P(SR)₂S- (trithiophosphonate ester); - B(SR)S- (thioborate ester); -BS₂- (thioborate); -Te- (tellurate) and -Se- (selenate);
wherein the group R and R' independently of each other represent small organic residues, such as methyl (CH₃), ethyl (CH₂CH₃), and phenyl (C₆H₅).

6. Molecular rectifying assembly according to any of claim 1 to 5, wherein the group BRIDGE is selected from pi-conjugated and non-conjugated parts, having the general structure (pi-conjugated)(non-conjugated) or (non-conjugated)(pi-conjugated)(non-conjugated) or (non-conjugated)ₓ(pi-conjugated)(non-conjugated)_{y}, wherein (non-conjugated)ₓ and (non-conjugated)y independently are different in length.

7. Molecular rectifying assembly according to claim 6, wherein the pi-conjugated part is selected from the group of 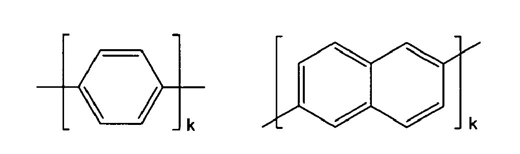 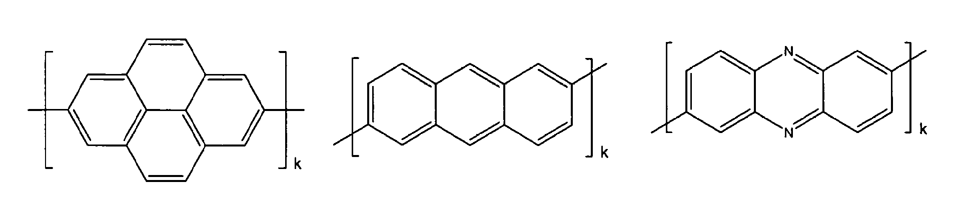 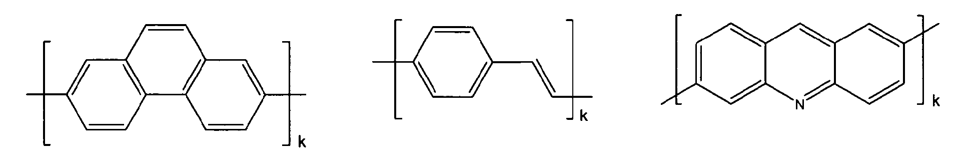 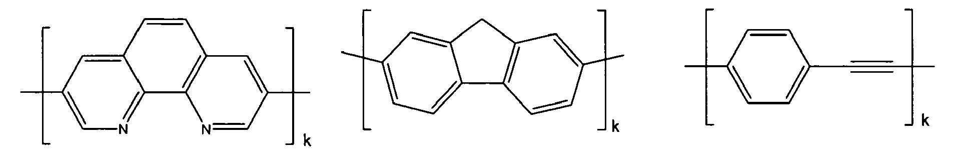 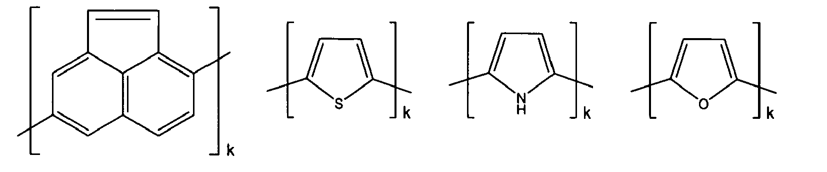 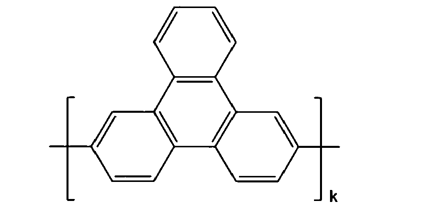 wherein k is selected from integers between and including 1 to 6, preferably between and including 1 to 4.

8. Molecular rectifying assembly according to claim 6 or 7, wherein the non-conjugated part is selected from the group of straight alkane chains, cyclic or polycyclic aliphatic carbon skeletons, 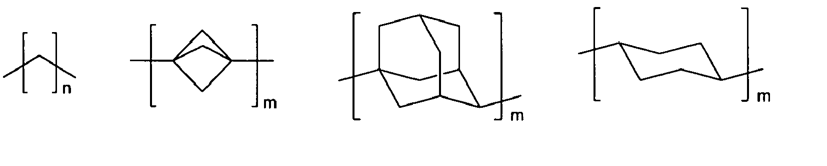 wherein n is selected from integers between and including 1 to 18, preferably between and including 1 to 16, and m is selected from integers between and including 1 to 5.

9. Molecular rectifying assembly according to any of claims 3, 4, and 6 to 8 wherein one of the metal connecting groups is a dithiocarbamate derivative selected from the general formula BRIDGE-NHCS₂-METAL and BRIDGE-NR'CS₂-METAL, wherein BRIDGE, R', and METAL are as indicated above.

10. Molecular rectifying assembly according to any of claims 6 to 9, wherein said non-conjugated parts independently have a length of between and including 1-23 Å.

11. A method for producing a molecular rectifying assembly according to any of claims 1 to 10, comprising the steps of providing different protecting groups and sequential deprotection of the metal connecting groups.

12. A method for producing a molecular rectifying assembly according to any of claims 1 to 11, comprising the steps of attaching a molecule having one metal connecting group at one of its ends to an electrode and subsequently chemically modifying the molecule to provide a metal connecting group at the other end of the molecule.

13. Use of a molecular rectifying assembly according to any of claims 1 to 12 for the production of electronic devices where molecules are placed between at least two electrodes.
